(19) Europäisches Patentamt
European Patent Office
Office européen des brevets

(11) EP 3 273 456 A1

(12) EUROPEAN PATENT APPLICATION
published in accordance with Art. 153(4) EPC

(43) Date of publication:
**24.01.2018 Bulletin 2018/04**

(21) Application number: **16764929.2**

(22) Date of filing: **14.03.2016**

(51) Int Cl.:
***H01G 9/20*** *(2006.01)*
***C09B 57/10*** *(2006.01)*
***C09B 69/00*** *(2006.01)*
***H01L 51/00*** *(2006.01)*

(86) International application number:
**PCT/JP2016/057952**

(87) International publication number:
**WO 2016/148099 (22.09.2016 Gazette 2016/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **17.03.2015 JP 2015054033**

(71) Applicant: **FUJI-FILM Corporation**
**Minato-ku**
**Tokyo 106-8620 (JP)**

(72) Inventors:
- **YOSHIOKA, Tomoaki**
  **Ashigarakami-gun**
  **Kanagawa 258-8577 (JP)**
- **TANI, Yukio**
  **Ashigarakami-gun**
  **Kanagawa 258-8577 (JP)**
- **WATANABE, Kousuke**
  **Ashigarakami-gun**
  **Kanagawa 258-8577 (JP)**
- **KOBAYASHI, Katsumi**
  **Ashigarakami-gun**
  **Kanagawa 258-8577 (JP)**

(74) Representative: **Beacham, Annabel Rose**
**Dehns**
**St Bride's House**
**10 Salisbury Square**
**London EC4Y 8JD (GB)**

# (54) PHOTOELECTRIC CONVERSION ELEMENT, DYE-SENSITIZED SOLAR CELL, RUTHENIUM COMPLEX DYE, AND DYE SOLUTION

(57) Provided are a photoelectric conversion element and a dye-sensitized solar cell, in which the photoconductor layer has semiconductor fine particles carrying a ruthenium complex dye represented by Formula (1); a ruthenium complex dye represented by Formula (1); and a dye solution including the dye.

$$RuL^1L^2SCN \qquad (1)$$

$L^1$ represents a specific terpyridine ligand and $L^2$ represents a bidentate ligand represented by Formula (L2).

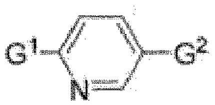
Formula (L2)

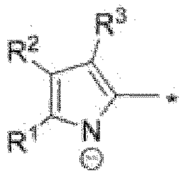
Formula (G1-1)

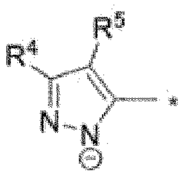
Formula (G1-2)

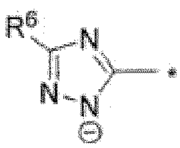
Formula (G1-3)

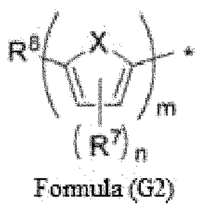
Formula (G2)

$G^1$ represents any one of Formulae (G1 -1) to (G1-3), and $G^2$ represents Formula (G2). $R^1$ to $R^6$, and $R^8$ each represent a hydrogen atom or a specific substituent. $R^7$ represents a specific a substituent. m represents 1 to 3, and n represents an integer of 0 to 2. X represents an oxygen atom, a sulfur atom, $NR^f$, a selenium atom, $CR^f_2$, or $SiR^f_2$. $R^f$

EP 3 273 456 A1

represents a hydrogen atom, an alkyl group, or an aryl group. * represents a bonding moiety.

FIG. 1

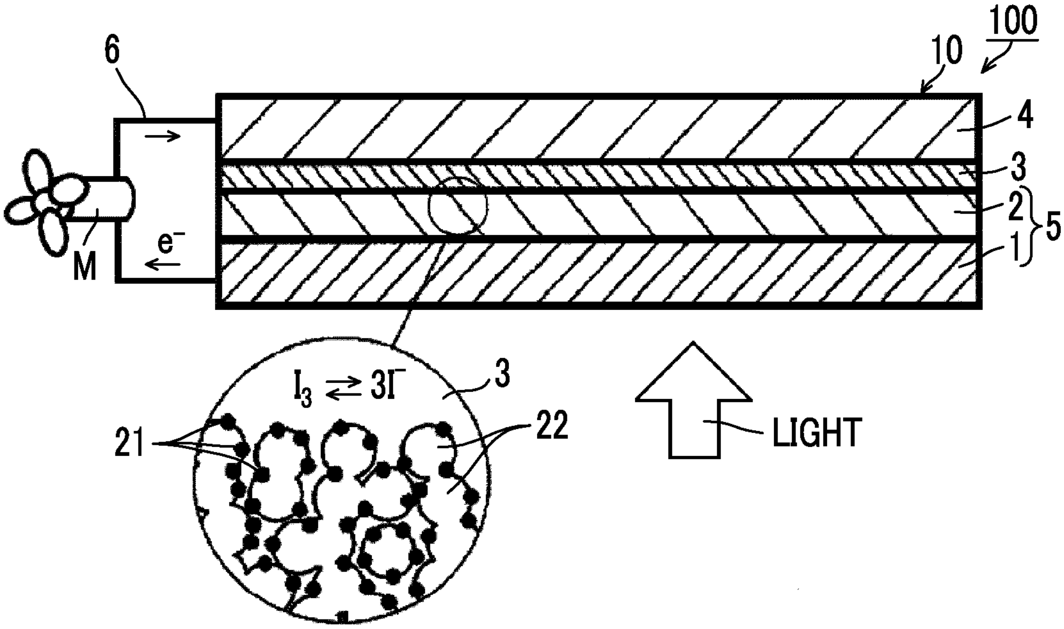

**Description**

**BACKGROUND OF THE INVENTION**

1. Field of the Invention

The present invention relates to a photoelectric conversion element, a dye-sensitized solar cell, a ruthenium complex dye, and a dye solution.

2. Description of the Related Art

Photoelectric conversion elements are used in various photosensors, copying machines, photoelectrochemical cells such as solar cells, and the like. These photoelectric conversion elements have adopted various systems to be put into use, such as systems utilizing metals, systems utilizing semiconductors, systems utilizing organic pigments or dyes, or combinations of these elements. In particular, solar cells utilizing inexhaustible solar energy do not necessitate fuels, and full-fledged practicalization of solar cells as an inexhaustible clean energy is being highly expected. Above all, research and development of silicon-based solar cells have long been in progress, and many countries also support policy-wise considerations, and thus dissemination of silicon-based solar cells is still in progress. However, silicon is an inorganic material, and thus, naturally has limitations in terms of improvement of throughput, cost, and the like.

Thus, research is being vigorously carried out on dye-sensitized solar cells. In particular, what have built momentum toward such research was the research results from Graetzel et al. of École Polytechnique Fédérale de Lausanne in Switzerland. They employed a structure in which a dye formed from a ruthenium complex was fixed on the surface of a porous titanium oxide film, and realized a photoelectric conversion efficiency which was comparable to that of amorphous silicon. Thus, dye-sensitized solar cells that can be produced even without use of expensive vacuum devices have instantly attracted the attention of researchers all over the world.

Hitherto, dyes called N3, N719, N749 (also referred to as Black Dye), Z907, and J2 have generally been developed as metal complex dyes for use in dye-sensitized solar cells.

Furthermore, in JP2014-209578A, a metal complex dye having a terpyridine ligand, a pyrazolylpyridine bidentate ligand having an aromatic heterocycle such as a thiophene ring at the 4-position of a pyridine ring, and a monodentate ligand, in which 1.0% by mole or more of isomers coexist, is described. In this publication, it is described in that the photoelectric conversion efficiency and the durability of a cell are improved by using the metal complex dye as a sensitizing dye.

In addition, in JP2013-72080A, a metal complex dye in which a terpyridine ligand, a specific pyridine-based bidentate ligand, and a monodentate ligand coordinate to a central metal is described. In this publication, it is described that the incident photon to current conversion efficiency (IPCE) of a long wavelength range of a cell can be enhanced and the durability is also improved by using the metal complex dye as a sensitizing dye.

**SUMMARY OF THE INVENTION**

For the practical application of a dye-sensitized solar cell, a high extent of durability which makes it possible to maintain photoelectric conversion performance stably is required in the field environment where the dye-sensitized solar cell is installed. In general, a sensitizing dye carried on the surface of semiconductor fine particles is easily released by the effect of moisture, and the photoelectric conversion efficiency tends to be easily lowered, particularly under a high humidity condition. Accordingly, for the practical application of the dye-sensitized solar cell, performance for improving moisture resistance and maintaining initial photoelectric conversion efficiency stably is required.

The present invention has an object to provide a photoelectric conversion element exhibiting excellent photoelectric conversion efficiency and having excellent moisture resistance, and a dye-sensitized solar cell using the photoelectric conversion element.

The present invention has another object to provide a ruthenium complex dye making it possible to produce a photoelectric conversion element or dye-sensitized solar cell which can be adsorbed onto the surface of semiconductor fine particles at a higher density, and exhibits excellent photoelectric conversion efficiency and a high extent of moisture resistance. The present invention has still another object to provide a dye solution which is suitable for formation of a photoconductor layer of the photoelectric conversion element or dye-sensitized solar cell of the present invention.

Taking the objects into consideration, the present inventors have conducted extensive studies and as a result, they have found that in a ruthenium complex dye in which a specific terpyridine ligand, a pyridine-based bidentate ligand, and a monodentate ligand coordinate to central ruthenium, by introducing a specific substituent into the 3-position of the pyridine ring of the pyridine-based bidentate ligand and adopting thiocyanate (-SCN) as the monodentate ligand, the adsorption density of the dye onto the surface of semiconductor fine particles can be increased, and by using the

ruthenium complex dye as a sensitizing dye, the photoelectric conversion efficiency of a solar cell can be enhanced and the moisture resistance can also be enhanced to a high extent. The present invention has led to completion by further conducting repeated studies based on these findings.

That is, the objects of the present invention have been achieved by the following means.

<1> A photoelectric conversion element comprising an electrically conductive support, a photoconductor layer including an electrolyte, a charge transfer layer including an electrolyte, and a counter electrode, in which the photoconductor layer has semiconductor fine particles carrying a ruthenium complex dye represented by Formula (1).

$$RuL^1L^2SCN \qquad (1)$$

In the formula, $L^1$ represents a tridentate ligand represented by Formula (L1), and $L^2$ represents a bidentate ligand represented by Formula (L2).

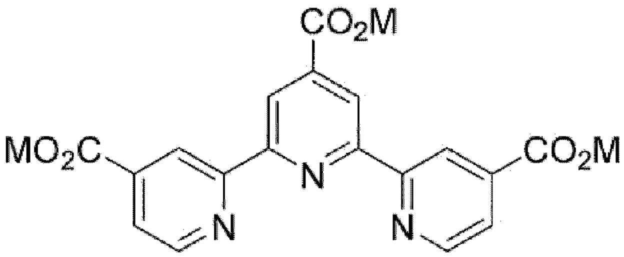

Formula (L1)

In the formula, M represents a hydrogen ion or a cation.

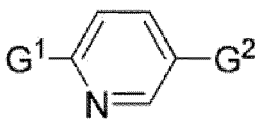

Formula (L2)

In the formula, $G^1$ represents a group represented by any one of Formulae (G1-1) to (G1-3), and $G^2$ represents a group represented by Formula (G2).

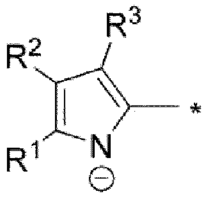

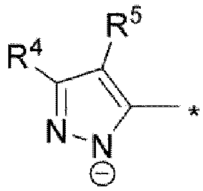

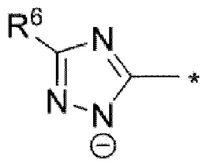

Formula (G1-1) Formula (G1-2) Formula (G1-3)

In the formulae, $R^1$ to $R^6$ each represent a hydrogen atom, an alkyl group, a heteroaryl group, an aryl group, or a halogen atom. * represents a bonding moiety to the pyridine ring in Formula (L2).

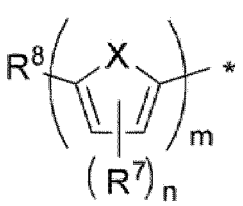

Formula (G2)

In the formula, $R^7$ represents an alkyl group, an alkynyl group, an alkenyl group, an alkoxy group, an alkylthio group, an amino group, a heteroaryl group, or an aryl group. $R^8$ represents a hydrogen atom, an alkyl group, an alkynyl group, an alkenyl group, an alkoxy group, an alkylthio group, an amino group, a heteroaryl group, or an aryl group. m represents an integer of 1 to 3. n represents an integer of 0 to 2. X represents an oxygen atom, a sulfur atom, $NR^f$, a selenium atom, $CR^f_2$, or $SiR^f_2$, in which $R^f$ represents a hydrogen atom, an alkyl group, or an aryl group. * represents a bonding moiety to the pyridine ring in Formula (L2).

<2> The photoelectric conversion element as described in <1>, in which in Formula (G2), X is a sulfur atom.

<3> The photoelectric conversion element as described in <1> or <2>, in which in Formula (L2), $G^1$ is represented by Formula (G1-2) or Formula (G1-3).

<4> The photoelectric conversion element as described in any one of <1> to <3>, in which in Formula (G1-2), $R^4$ is an alkyl group.

<5> The photoelectric conversion element as described in any one of <1> to <4>, in which in Formula (G1-2), $R^5$ is a hydrogen atom.

<6> A dye-sensitized solar cell comprising the photoelectric conversion element as described in any one of <1> to <5>.

<7> A ruthenium complex dye represented by Formula (1).

$$RuL^1L^2SCN \qquad (1)$$

In the formula, $L^1$ represents a tridentate ligand represented by Formula (L1), and $L^2$ represents a bidentate ligand represented by Formula (L2).

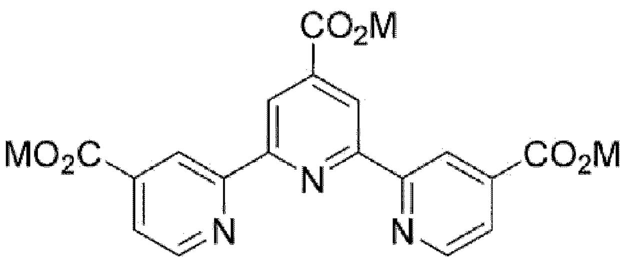

Formula (L1)

In the formula, M represents a hydrogen ion or a cation.

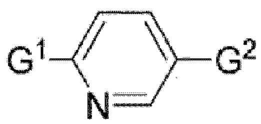

Formula (L2)

In the formula, $G^1$ represents a group represented by any one of Formulae (G1-1) to (G1-3), and $G^2$ represents a group represented by Formula (G2).

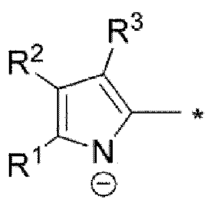

Formula (G1-1)

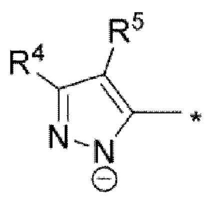

Formula (G1-2)

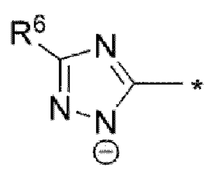

Formula (G1-3)

In the formulae, $R^1$ to $R^6$ each represent a hydrogen atom, an alkyl group, a heteroaryl group, an aryl group, or a halogen atom. * represents a bonding moiety to the pyridine ring in Formula (L2).

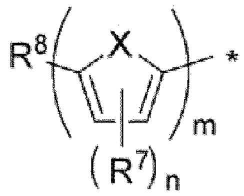

Formula (G2)

In the formula, $R^7$ represents an alkyl group, an alkynyl group, an alkenyl group, an alkoxy group, an alkylthio group, an amino group, a heteroaryl group, or an aryl group. $R^8$ represents a hydrogen atom, an alkyl group, an alkynyl group, an alkenyl group, an alkoxy group, an alkylthio group, an amino group, a heteroaryl group, or an aryl group. m represents an integer of 1 to 3. n represents an integer of 0 to 2. X represents an oxygen atom, a sulfur atom, $NR^f$, a selenium atom, $CR^f_2$, or $SiR^f_2$, in which $R^f$ represents a hydrogen atom, an alkyl group, or an aryl group. * represents a bonding moiety to the pyridine ring in Formula (L2).

<8> A dye solution comprising the ruthenium complex dye as described in <7>.

In the present specification, with regard to indications of compounds or complexes, unless otherwise specified, in a case where the E configuration and Z configuration exist in the molecule for a double bond or in a case where R isomers and S isomers exist within a molecule for an asymmetrical carbon atom, the double bond or asymmetrical carbon atom may be either one of the two configurations or a mixture thereof.

When there are a plurality of substituents, linking groups, ligands, or the like (hereinafter referred to as substituents or the like) represented by specific symbols or formulae, or when a plurality of substituents and the like are defined at the same time, the respective substituents or the like may be the same as or different from each another unless otherwise specified. This also applies to the definition of the number of substituents or the like. Further, when a plurality of substituents and the like are close to each other (in particular, adjacent to each other), they may be linked to each other to form a ring unless otherwise specified.

Furthermore, the ring, for example, an aromatic ring or an aliphatic ring may further be fused to form a fused ring.

In the present specification, expressions of a compound (including a complex and a dye) are meant to encompass, in addition to the compound itself, salts and ions of the compound. Further, within a range exhibiting desired effects, the expressions are used to mean inclusion of modifications of a part of the structure. In addition, a compound in which substitution or non-substitution is not explicitly described is meant to indicate that compound may have an arbitrary substituent within a range exhibiting the desired effects. This also applies to substituents, linking groups, and ligands.

Moreover, in the present specification, a numerical value range represented by "(a value) to (a value)" means a range including the numerical values represented before and after "to" as a lower limit value and an upper limit value, respectively.

The photoelectric conversion element and the dye-sensitized solar cell of the present invention has a photoelectric conversion efficiency which is hard to decrease even in an external environment with high humidity, and exhibits a high extent of moisture resistance. Further, the ruthenium complex dye of the present invention can be adsorbed with a high density on the surface of semiconductor fine particles, and makes it possible to produce a photoelectric conversion element or dye-sensitized solar cell exhibiting excellent photoelectric conversion efficiency and a high extent of moisture resistance. In addition, the dye solution of the present invention can be suitably used to form the photoconductor layer of the photoelectric conversion element or dye-sensitized solar cell of the present invention.

The above and other characteristics and advantages of the present invention will be further clarified from the following description appropriately with reference to drawings attached hereto.

**BRIEF DESCRIPTION OF THE DRAWINGS**

Fig. 1 is a cross-sectional view schematically showing a photoelectric conversion element in the first aspect of the present invention, including an enlarged view of the circled portion in the layer thereof, in a system in which the photoelectric conversion element is applied in cell uses.

Fig. 2 is a cross-sectional view schematically showing a dye-sensitized solar cell including a photoelectric conversion element in the second aspect of the present invention.

## DESCRIPTION OF THE PREFERRED EMBODIMENTS

[Photoelectric Conversion Element and Dye-Sensitized Solar Cell]

The photoelectric conversion element of the present invention has an electrically conductive support, a photoconductor layer including an electrolyte, a charge transfer layer including an electrolyte, and a counter electrode (opposite electrode). The photoconductor layer, the charge transfer layer, and the counter electrode are provided in this order on the electrically conductive support.

In the photoelectric conversion element of the present invention, at least a portion of the semiconductor fine particles forming the photoconductor layer carries a ruthenium complex dye represented by Formula (1) which will be described later, as a sensitizing dye. Here, the aspect in which the ruthenium complex dye is carried onto the surface of the semiconductor fine particles encompasses an aspect in which the ruthenium complex dye is deposited on the surface of the semiconductor fine particles, an aspect in which the ruthenium complex dye is adsorbed onto the surface of the semiconductor fine particles, and a mixture of the aspects. The adsorption includes chemical adsorption and physical adsorption, with the chemical adsorption being preferable.

The semiconductor fine particles may carry other metal complex dyes, together with a ruthenium complex dye of Formula (1) which will be described later.

Moreover, the photoconductor layer includes an electrolyte. The electrolyte included in the photoconductor layer may be the same as or different from the electrolyte included in the charge transfer layer, but they are preferably the same.

The photoelectric conversion element of the present invention is not particularly limited in terms of configurations other than the configuration defined in the present invention, and may adopt known configurations regarding photoelectric conversion elements. The respective layers constituting the photoelectric conversion element of the present invention are designed depending on purposes, and may be formed into, for example, a single layer or multiple layers. Further, layers other than the layers may be included, as necessary.

The dye-sensitized solar cell of the present invention is formed by using the photoelectric conversion element of the present invention.

Hereinafter, preferred embodiments of the photoelectric conversion element and the dye-sensitized solar cell of the present invention will be described.

A system 100 shown in Fig. 1 is a system in which a photoelectric conversion element 10 in the first aspect of the present invention is applied in cell uses where an operating means M (for example, an electric motor) in an external circuit 6 is forced to work.

The photoelectric conversion element 10 includes semiconductor fine particles 22 sensitized by carrying an electrically conductive support 1 and a dye (ruthenium complex dye) 21, a photoconductor layer 2 including an electrolyte between the semiconductor fine particles 22, a charge transfer layer 3 that is a hole transport layer, and a counter electrode 4.

In the photoelectric conversion element 10, the light-receiving electrode 5 has the electrically conductive support 1 and the photoconductor layer 2, and functions as a functional electrode.

In the system 100 in which the photoelectric conversion element 10 is applied, light incident to the photoconductor layer 2 excites the ruthenium complex dye 21. The excited ruthenium complex dye 21 has electrons having high energy, and these electrons are transferred from the ruthenium complex dye 21 to a conduction band of the semiconductor fine particles 22, and further reach the electrically conductive support 1 by diffusion. At this time, the ruthenium complex dye 21 is in an oxidized form (cation). While the electrons reaching the electrically conductive support 1 work in an external circuit 6, they reach the oxidized form of the ruthenium complex dye 21 through the counter electrode 4 and the charge transfer layer 3, and reduce the oxidized form, whereby the system 100 functions as a solar cell.

A dye-sensitized solar cell 20 shown in Fig. 2 is constituted with a photoelectric conversion element in the second aspect of the present invention.

With respect to the photoelectric conversion element shown in Fig. 1, the photoelectric conversion element which becomes the dye-sensitized solar cell 20 is different in the configurations of the electrically conductive support 41 and the photoconductor layer 42, and also differs in that it has a spacer S, but except for these, has the same configuration as the photoelectric conversion element 10 shown in Fig. 1. That is, the electrically conductive support 41 has a bilayered structure including a substrate 44 and a transparent electrically-conductive film 43 which is formed on the surface of the substrate 44. Further, the photoconductor layer 42 has a bilayered structure including a semiconductor layer 45 and a light-scattering layer 46 which is formed adjacent to the semiconductor layer 45. A spacer S is provided between the electrically conductive support 41 and the counter electrode 48. In the dye-sensitized solar cell 20, 40 is a light-receiving electrode and 47 is a charge transfer layer.

The dye-sensitized solar cell 20, similar to the system 100 in which the photoelectric conversion element 10 is applied, functions as a solar cell by light incident on the photoconductor layer 42.

The photoelectric conversion element and the dye-sensitized solar cell of the present invention are not limited to the above preferred aspects, and the configuration of each of the aspects can be combined as appropriate within a range not departing from the scope of the present invention.

In the present invention, the materials and the respective members for use in the photoelectric conversion element and the dye-sensitized solar cell can be prepared by ordinary methods. Reference can be made to, for example, US4927721A, US4684537A, US5084365A, US5350644A, US5463057A, US5525440A, JP1995-249790A (JP-H07-249790A), JP2001-185244A, JP2001-210390A, JP2003-217688A, JP2004-220974A, and JP2008-135197A.

<Ruthenium Complex Dye>

- Ruthenium Complex Dye Represented by Formula (1) -

The ruthenium complex dye of the present invention is represented by Formula (1).

$$RuL^1L^2SCN \qquad (1)$$

In the formula, $L^1$ represents a tridentate ligand represented by Formula (L1), and $L^2$ represents a bidentate ligand represented by Formula (L2). SCN is a thiocyanate group which coordinates to ruthenium through a sulfur atom.

Hereinafter, each of the ligands $L^1$ and $L^2$ will be described in this order.

- Ligand $L^1$ -

The ligand $L^1$ is represented by Formula (L1)

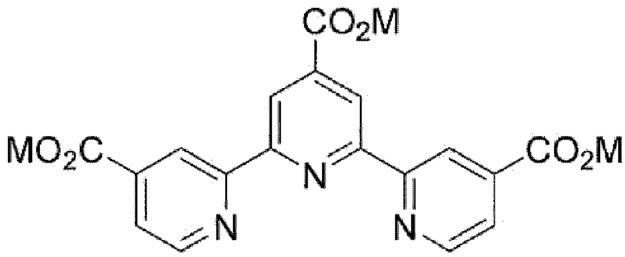

Formula (L1)

In the formula, M represents a hydrogen ion or a cation.

The cation which can be adopted by M is not particularly limited, but examples thereof include positive counterions (excluding a hydrogen ion) in the following counterions CI. Among those, an alkali metal ion or an ammonium ion is preferable.

- Ligand $L^2$ -

The ligand $L^2$ is represented by Formula (L2).

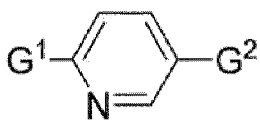

Formula (L2)

In the formula, $G^1$ represents a group represented by any one of Formulae (G1-1) to (G1-3), and $G^2$ is a group represented by Formula (G2) which will be described later.

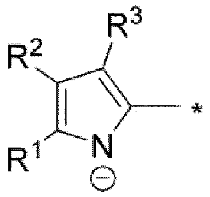
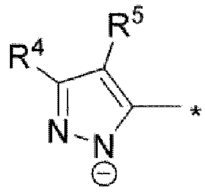
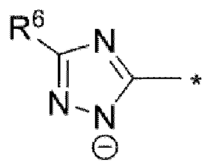

Formula (G1-1) Formula (G1-2) Formula (G1-3)

In the formulae, $R^1$ to $R^6$ each represent a hydrogen atom, an alkyl group, a heteroaryl group, an aryl group, or a halogen atom. * represents a bonding moiety to the pyridine ring in Formula (L2).

Preferred aspects of the alkyl group, the heteroaryl group, the aryl group, and the halogen atom in $R^1$ to $R^6$ are the same as the preferred aspects of the group corresponding to the substituent $Z^R$ which will be described later.

The alkyl group which can be adopted by $R^1$ to $R^6$ is more preferably an alkyl group substituted with an electron withdrawing group, and still more preferably a halogen atom, in particular, an alkyl group substituted with a fluorine atom. In the alkyl group substituted with a hydrogen atom, the number of halogen atoms for the substitution is not particularly limited, and is 1 or more, preferably no more than the number of hydrogen atoms contained in the alkyl group before the substitution, more preferably 1 to 6, and still more preferably 1 to 3. Among these, the alkyl group substituted with a halogen atom is preferably a perhalogenated alkyl group in which all of the hydrogen atoms contained in the alkyl group are substituted, more preferably a perfluoroalkyl group, and still more preferably trifluoromethyl.

The aryl group which can be adopted by $R^1$ to $R^6$ is more preferably an aryl group substituted with an electron withdrawing group, and still more preferably a halogen atom, in particular, an aryl group substituted with a fluorine atom. In the aryl group substituted with a hydrogen atom, the number of halogen atoms for the substitution is not particularly limited, and is 1 or more, preferably no more than the number of hydrogen atoms contained in the aryl group before the substitution, more preferably 2 to 5, and still more preferably 3 to 5. Among these, the aryl group substituted with a halogen atom is preferably a phenyl group substituted with a halogen atom, and examples thereof include 2,3,4,5-tetrafluorophenyl and 2,3,4,5,6-pentafluorophenyl.

$R^2$, $R^4$, and $R^6$ are each preferably, among the respective above-mentioned groups, an alkyl group, an aryl group, or a heteroaryl group, more preferably an alkyl group substituted with a fluorine atom or an aryl group substituted with a fluorine atom, and still more preferably an alkyl group substituted with a fluorine atom.

$R^1$ is preferably a hydrogen atom.

$R^3$ and $R^5$ are each preferably, among the respective above-mentioned groups, a hydrogen atom or an alkyl group, more preferably a hydrogen atom or an alkyl group having 1 to 3 carbon atoms, and still more preferably a hydrogen atom.

$G^1$ is preferably a group represented by Formula (G1-2) or Formula (G1-3), and more preferably a group represented by Formula (G1-2).

In the group represented by Formula (G1-2), it is more preferable that $R^4$ is an alkyl group and $R^5$ is a hydrogen atom, and it is still more preferable that $R^4$ is an alkyl group substituted with a fluorine atom and $R^5$ is a hydrogen atom.

$G^2$ is a group represented by Formula (G2).

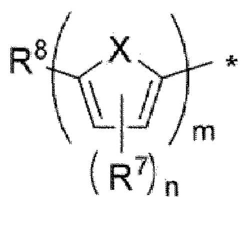

Formula (G2)

In the formula, $R^7$ represents an alkyl group, an alkynyl group, an alkenyl group, an alkoxy group, an alkylthio group, an amino group, a heteroaryl group, or an aryl group. $R^8$ represents a hydrogen atom, an alkyl group, an alkynyl group, an alkenyl group, an alkoxy group, an alkylthio group, an amino group, a heteroaryl group, or an aryl group.

m represents an integer of 1 to 3. n represents an integer of 0 to 2.

X represents an oxygen atom, a sulfur atom, $NR^f$, a selenium atom, $CR^f_2$, or $SiR^f_2$, in which $R^f$ represents a hydrogen atom, an alkyl group, or an aryl group. * represents a bonding moiety to the pyridine ring in Formula (L2).

Preferred aspects of the respective groups which can be adopted by $R^7$, $R^8$ and, $R^f$ are the same as the preferred aspects of the group corresponding to the substituent $Z^R$ which will be described later.

$R^7$ is preferably, among the respective above-mentioned groups, an alkyl group, an alkoxy group, an alkylthio group, an amino group, an aryl group, or a heteroaryl group, more preferably an alkyl group, an alkoxy group, an alkylthio group, an amino group, or a heteroaryl group, and still more preferably an alkyl group, an alkoxy group, or an alkylthio group.

n is preferably 0 or 1, in a case where $R^8$ is a hydrogen atom, n is more preferably 1, and in a case where $R^8$ is not a hydrogen atom, n is more preferably 0.

In a case where n is 2, two $R^7$'s may be bonded to each other to form a ring, and adjacent $R^7$ and $R^8$ may be bonded to each other to form a ring. Examples of the ring to be formed include aryl rings such as a benzene ring and heteroaryl rings such as a pyrazine ring and a pyrrole ring; unsaturated hydrocarbon rings not exhibiting aromaticity, such as a cyclopentadiene ring; and heterocycles not exhibiting aromaticity, such as a 1,4-dioxane ring and a 2,3-dihydropyrazine ring.

$R^8$ is preferably, among the respective above-mentioned groups, a hydrogen atom, an alkyl group, an alkynyl group, an alkenyl group, an alkoxy group, an alkylthio group, or an amino group, more preferably an alkyl group, an alkynyl group, an alkenyl group, an alkoxy group, or an alkylthio group, and still more preferably an alkyl group, an alkenyl group, or an alkylthio group. The heteroaryl group which can be adopted by $R^8$ does not include a ring containing X in Formula (G2).

X is preferably an oxygen atom or a sulfur atom, and more preferably a sulfur atom.

m is preferably 1 or 2, and more preferably 1.

In a case where m is 2 or 3, and among $R^7$'s containing ring including adjacent X's, $R^7$ having a ring including one of X's is bonded to the ring including the other X to form a ring, or $R^7$'s having a ring including adjacent two X's may be bonded to each other to form a ring. The ring to be formed has the same definition as the ring formed by $R^7$.

The group represented by Formula (G2) is preferably a group represented by any one of Formulae (G2-1a) to (G2-5a), preferably a group represented by Formula (G2-1a) or Formula (G2-5a), and more preferably a group represented by Formula (G2-1a).

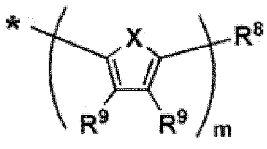
Formula (G2-1a)

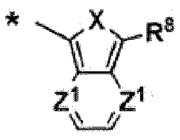
Formula (G2-2a)

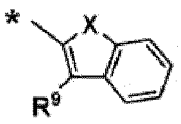
Formula (G2-3a)

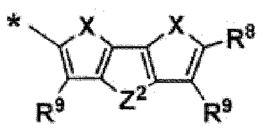
Formula (G2-4a)

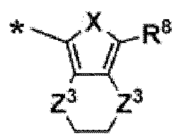
Formula (G2-5a)

In Formulae (G2-1a) to (G2-5a), $R^8$, X, and m each have the same definitions as $R^8$, X, and m, respectively, in Formula (G2), and preferred ranges thereof are also the same. $R^9$ represents a hydrogen atom, an alkyl group, an alkynyl group, an alkenyl group, an alkoxy group, an alkylthio group, an amino group, a heteroaryl group, or an aryl group. The alkyl group, the alkynyl group, the alkenyl group, the alkoxy group, the alkylthio group, the amino group, the heteroaryl group, and aryl group, which can be adopted by $R^9$, each have the same definitions as the alkyl group, an alkynyl group, an alkenyl group, an alkoxy group, an alkylthio group, an amino group, a heteroaryl group and aryl group which can be adopted by $R^7$ in Formula (G2), and preferred ranges thereof are also the same.

$Z^1$ is preferably a nitrogen atom, $CR^a$, or a nitrogen atom.

$Z^2$ and $Z^3$ each independently represent an oxygen atom, a sulfur atom, $NR^b$, $CR^b_2$, a selenium atom, or $SiR^b_2$. $Z^2$ is preferably $NR^b$ or $CR^b_2$, and $Z^3$ is preferably an oxygen atom or a sulfur atom, and more preferably an oxygen atom.

$R^a$ and $R^b$ each represent a hydrogen atom or an alkyl group. Preferred aspects of the alkyl group which can be adopted by $R^a$ and $R^b$ are the same as the preferred aspects in the substituent $Z^R$ which will be described later.

The ruthenium complex dye represented by Formula (1) has a 3-dimensional structure in which a terpyridine ligand, a bidentate ligand formed of a nitrogen-containing, 5-membered ring and a pyridine ring (hereinafter simply referred to as a bidentate ligand), or -SCN (thiocyanate group) octahedrally coordinates to Ru.

As shown in Formula (1), by introducing a substituent $G^2$ to the 3-position of the pyridine ring (the 5-position in a case where a carbon atom bonded to a nitrogen-containing, 5-membered ring is placed at the 2-position on the basis of a nitrogen atom coordinating to ruthenium in the pyridine ring) in the bidentate ligand, and adopting a thiocyanate group as the monodentate ligand, the adsorption amount of the ruthenium complex dye onto the surface of semiconductor fine particles can be increased. Further, in the photoelectric conversion element or dye-sensitized solar cell, in which the dye is used as a sensitizing dye, both of photoelectric conversion efficiency and moisture resistance can be realized to a high extent of level. The reason therefor is presumed as follows.

That is, it is considered that by introducing a substituent $G^2$ to the 3-position of the pyridine ring in the bidentate ligand of the ruthenium complex dye, an interaction between the surface of semiconductor fine particles and the dye becomes stronger relatively, among interactions between the dye and the dye, between the dye and the additive, and

between the surface of semiconductor fine particles and the dye, acting on the ruthenium complex dye, in the photoconductor layer. It is considered that the interaction between the surface of semiconductor fine particles and the dye, and the interaction between the N atom of the thiocyanate group which is a monodentate ligand and the surface of semiconductor fine particles are combined to increase the adsorption amount onto the surface of semiconductor fine particles. In addition, it is considered that since the interaction between the N atom of the thiocyanate group and the surface of semiconductor fine particles is relatively strong, the substituent $G^2$ present in the periphery is more strongly attracted to the surface of semiconductor fine particles, the approach of water molecules can be effectively prevented.

Here, in the ruthenium complex dye represented by Formula (1) that is used in the present invention, the monodentate ligand is a thiocyanate group: -SCN (coordinating to ruthenium through an S atom), not an isothiocyanate group: -NCS (coordinating to ruthenium through an N atom). The sensitizing dye for use in the photoelectric conversion element of the present invention may include a ruthenium complex dye having an isothiocyanate group which is a bond isomer of the ruthenium complex dye represented by Formula (1) as a monodentate ligand, and the amount thereof in terms of a molar ratio is preferably 20 or less, more preferably 10 or less, still more preferably 5 or less, particularly preferably 3 or less, and most preferably 2 or less, with respect to 100 of the ruthenium complex dye represented by Formula (1). By setting the content of the bond isomer of the ruthenium complex dye represented by Formula (1) within the range, the effect of the present invention can be more effectively expressed.

In addition, in a case where the ruthenium complex dye represented by Formula (1) is a cation of M, the binding position of the cation may be any one of three pyridine rings of the terpyridine ligand. Further, the ruthenium complex dye represented by Formula (1) for use in the photoelectric conversion element of the present invention may be a mixture of dyes having different cations.

The ruthenium complex dye represented by Formula (1) and the bond isomer can be confirmed (identified or quantitatively determined) from peaks shown at different positions (retention times) in high performance liquid chromatography (HPLC). Specifically, the determination can be performed using a high performance liquid chromatography device (Shimadzu Corporation), based on the area ratio of the peaks of the respective bond isomers, obtained using a column of YMC-Pac ODS-AM12S-05-1506WTAM-312, a temperature of 40°C, a detection wavelength of 254 nm, a flow rate of 1.0 mL/min, and an eluent of tetrahydrofuran (THF)/water/trifluoroacetic acid (TFA) = 50/50/0.1 as the measurement conditions.

In the present specification, the ruthenium complex dye represented by Formula (1) also encompasses an aspect in which a counterion (CI) for neutralizing the charges of the dye is included.

In a case where the counterion CI is a positive counterion, for example, the counterion CI is an inorganic or organic ammonium ion (for example, a tetraalkylammonium ion and a pyridinium ion), a phosphonium ion (for example, a tetraalkylphosphonium ion and an alkyltriphenylphosphonium ion), an alkali metal ion (a Li ion, a Na ion, a K ion, and the like), an alkaline earth metal ion, a metal complex ion, or a hydrogen ion. As the positive counterion, an inorganic or organic ammonium ion (a tetraethylammonium ion, a tetrabutylammonium ion, and the like), or a hydrogen ion is preferable.

In a case where the counterion CI is a negative counterion, the counterion CI is, for example, an inorganic anion or an organic anion. Examples thereof include a hydroxide ion, a halogen anion (for example, a fluoride ion, a chloride ion, a bromide ion, and an iodide ion), a substituted or unsubstituted alkylcarboxylate ion (for example, an acetate ion and a trifluoroacetate ion), a substituted or unsubstituted arylcarboxylate ion (for example, a benzoate ion), a substituted or unsubstituted alkylsulfonate ion (for example, a methanesulfonate ion and a trifluoromethanesulfonate ion), a substituted or unsubstituted arylsulfonate ion (for example, a p-toluene sulfonate ion and a p-chlorobenzene sulfonate ion), an aryldisulfonate ion (for example, a 1,3-benzene disulfonate ion, a 1,5-naphthalene disulfonate ion, and a 2,6-naphthalene disulfonate ion), an alkylsulfate ion (for example, a methylsulfate ion), a sulfate ion, a thiocyanate ion, a perchlorate ion, a tetrafluoroborate ion, a hexafluorophosphate ion, and a picrate ion. Alternatively, as a charge balance counterion, an ionic polymer or another dye with an opposite charge from the dye in interest may be used, or a metal complex ion (for example, a bisbenzene-1,2-dithiolatonickel (III)) may also be used. As the negative counterion, a halogen anion, a substituted or unsubstituted alkylcarboxylate ion, a substituted or unsubstituted alkylsulfonate ion, a substituted or unsubstituted arylsulfonate ion, an aryldisulfonate ion, a perchlorate ion, and a hexafluorophosphate ion are preferable, and a halogen anion and a hexafluorophosphate ion are more preferable.

The ruthenium complex dye represented by Formula (1) can be synthesized by, for example, the method described in JP2013-084594A, the method described in JP4298799B, the method described in each specification of US2013/0018189A1, US2012/0073660A1, US2012/0111410A1, and US2010/0258175A1, the method described in Angew. Chem. Int. Ed., 2011, 50, pp. 2054-2058, the method described in Chem. Commun., 2014, 50, 6379-6381, the methods described in the reference documents listed in these documents, the patent documents regarding solar cells, known methods, or the methods equivalent thereto.

The ruthenium complex dye represented by Formula (1) is usually synthesized as a mixture including isomers. By purifying this mixture, the ruthenium complex dye represented by Formula (1) can be isolated.

In particular, for the mixture with the bond isomer of the ruthenium complex dye represented by Formula (1),

a mixture including a large amount of the ruthenium complex dye represented by Formula (1) can be obtained by changing the ligand concentration, the heating temperature, or the solvent at the time of introducing the monodentate ligand into the metal.

The ruthenium complex dye represented by Formula (1) has a maximum absorption wavelength in a solution, preferably in a range of 300 to 900 nm, more preferably in a range of 350 to 850 nm, and particularly preferably in a range of 370 to 800 nm. In addition, the absorption wavelength range is preferably throughout a region from 300 to 900 nm.

Specific preferred examples of the ruthenium complex dye represented by Formula (1) are shown below, but the present invention is not limited thereto. In a case where the following specific examples of the ruthenium complex dye include a ligand having a proton-dissociative group, the ligand may be dissociated to emit protons, if necessary.

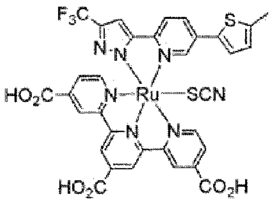
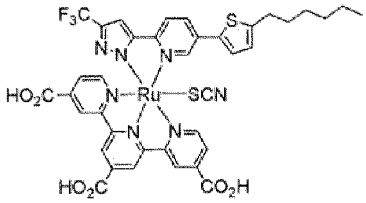
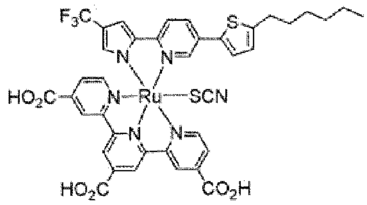
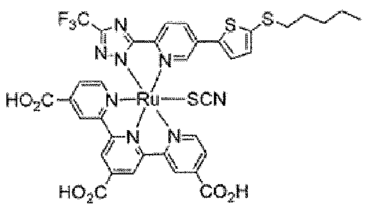
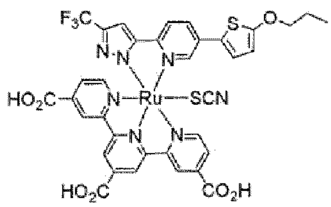
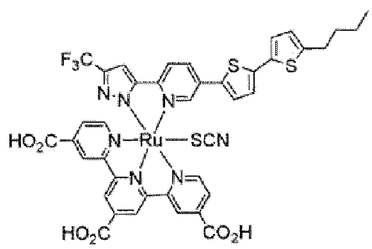
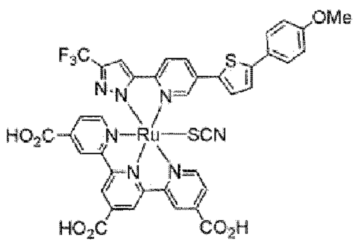
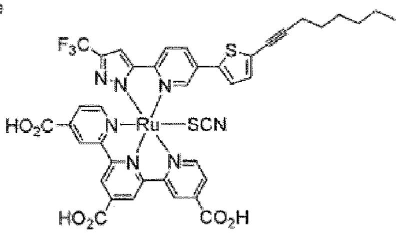
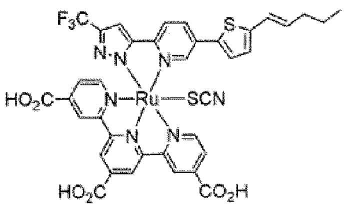
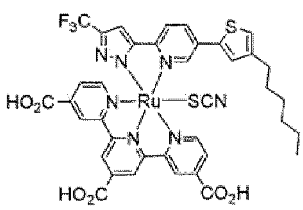
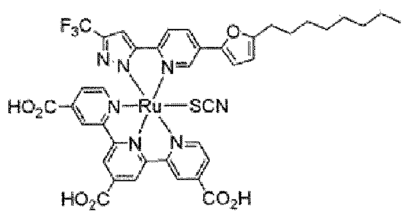
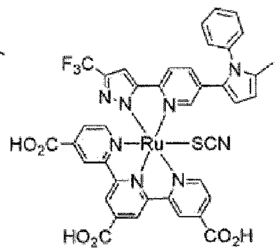
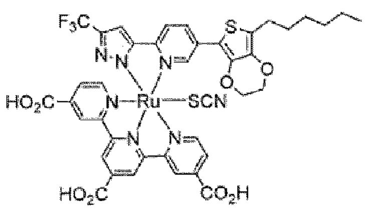
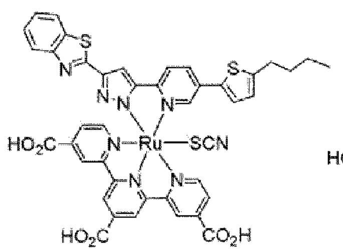
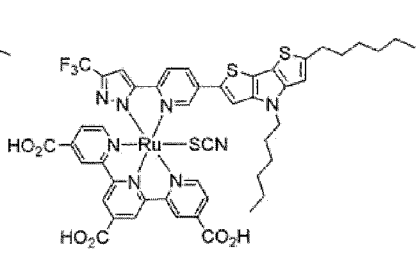

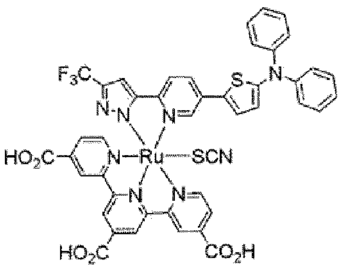
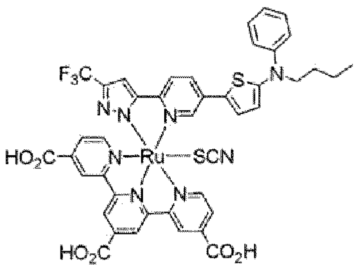
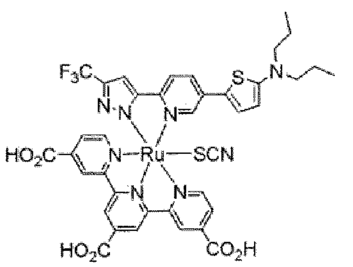
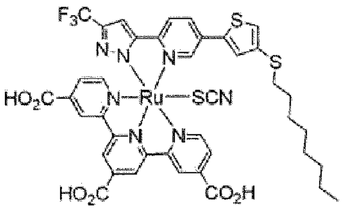
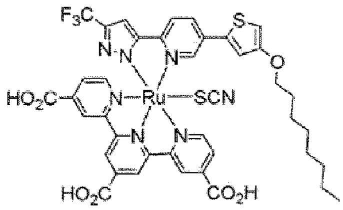
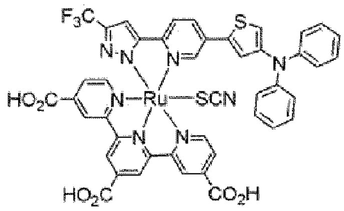
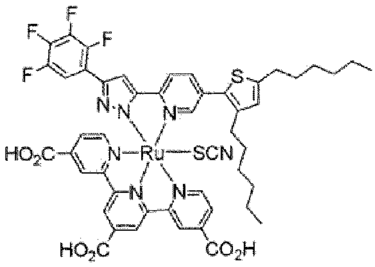
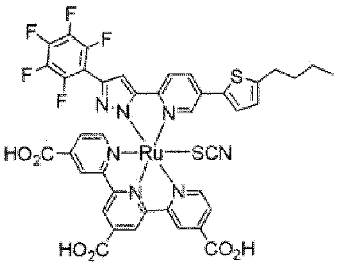
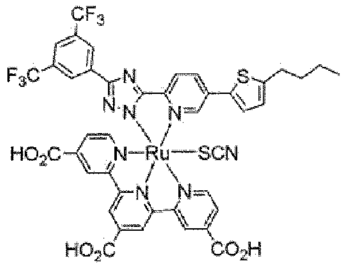
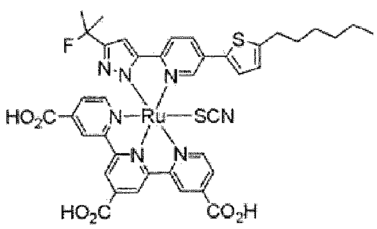
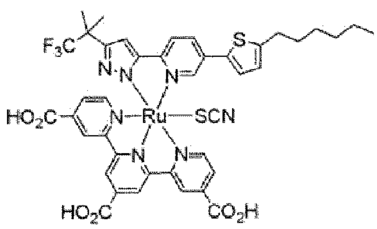
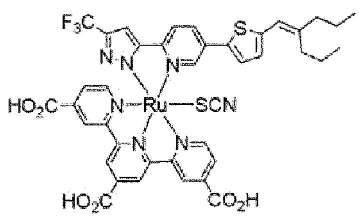
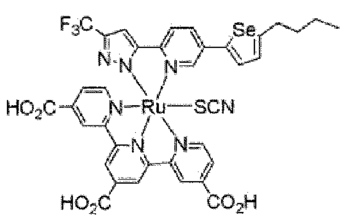
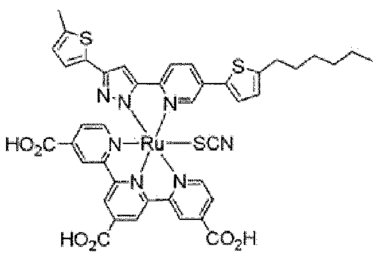
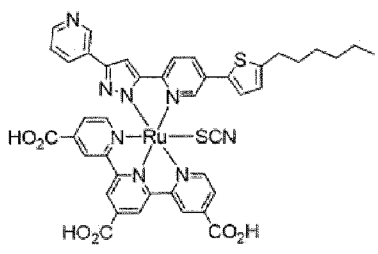

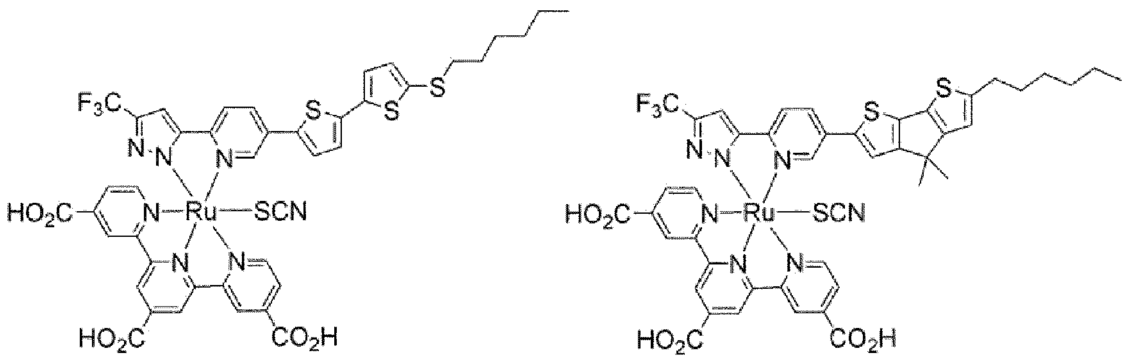

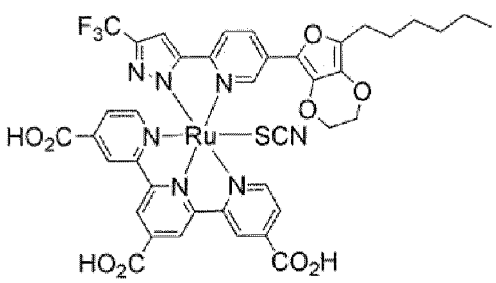

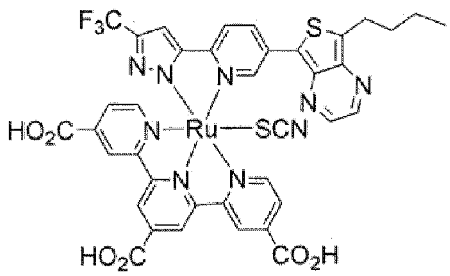

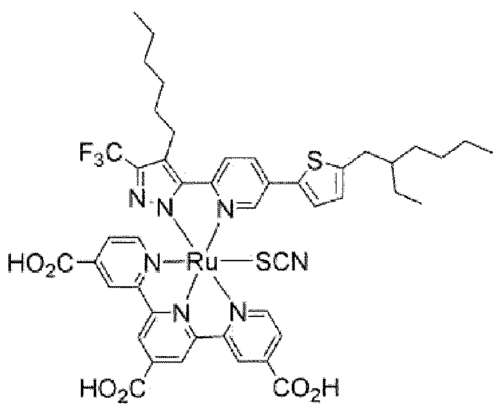

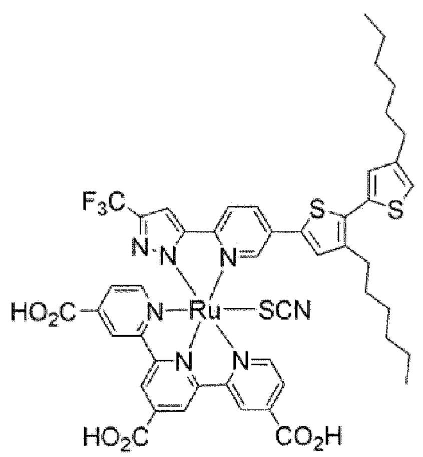

<Substituent Group $Z^R$>

Examples of the substituent in the present invention include the substituents selected from the following substituent group $Z^R$.

In the present specification, in a case where there is only a simple description of a substituent, reference is made to this substituent group $Z^R$. Further, in a case where each of the groups (for example, an alkyl group and an aryl group) is merely described, preferred ranges and specific examples for the corresponding group (for example, the alkyl group and the aryl group in $Z^R$) for the substituent group $Z^R$ are applied.

Examples of the groups included in the substituent group $Z^R$ include the following groups and the groups formed by the combination of a plurality of the following groups:

an alkyl group (preferably an alkyl group having 1 to 20 carbon atoms, and more preferably an alkyl group having 1 to 12 carbon atoms, for example, methyl, ethyl, isopropyl, n-butyl, t-butyl, pentyl, hexyl, heptyl, octyl, 1-ethylpentyl, 2-ethylhexyl, benzyl, 2-ethoxyethyl, and trifluoromethyl), an alkenyl group (preferably an alkenyl group having 2 to 20 carbon atoms, and more preferably an alkenyl group having 2 to 12 carbon atoms, for example, vinyl, allyl, butenyl, and oleyl), an alkynyl group (preferably an alkynyl group having 2 to 20 carbon atoms, and more preferably an alkynyl group having 2 to 12 carbon atoms, for example, ethynyl, butynyl, octynyl, and phenylethynyl), a cycloalkyl group (preferably a cycloalkyl group having 3 to 20 carbon atoms), an cycloalkenyl group (preferably a cycloalkenyl

group having 5 to 20 carbon atoms), an aryl group (preferably an aryl group having 6 to 26 carbon atoms, for example, phenyl, 1-naphthyl, 4-methoxyphenyl, 2-chlorophenyl, 3-methylphenyl, difluorophenyl, and tetrafluorophenyl), a heterocyclic group (preferably a heterocyclic group having 2 to 20 carbon atoms, and more preferably a 5- or 6-membered heterocyclic group having at least one oxygen atom, sulfur atom, or nitrogen atom. The heterocyclic group encompasses a heteroaryl group exhibiting aromaticity and an aliphatic heterocyclic group not exhibiting aromaticity. Examples of the aromatic heterocyclic group include 2-pyridyl, 2-thienyl, 2-furanyl, 3-pyridyl, 4-pyridyl, 2-imidazolyl, 2-benzimidazolyl, 2-thiazolyl, 2-benzothiazolyl, and 2-oxazolyl), an alkoxy group (preferably an alkoxy group having 1 to 20 carbon atoms, and more preferably an alkoxy group having 1 to 12 carbon atoms, for example, methoxy, ethoxy, propyloxy, hexyloxy, octyloxy, and benzyloxy), an alkenyloxy group (preferably an alkenyloxy group having 2 to 20 carbon atoms, and more preferably an alkenyloxy group having 2 to 12 carbon atoms), an alkynyloxy group (preferably an alkynyloxy group having 2 to 20 carbon atoms, and more preferably an alkynyloxy group 2 to 12 carbon atoms), a cycloalkyloxy group (preferably a cycloalkyloxy group having 3 to 20 carbon atoms), an aryloxy group (preferably an aryloxy group having 6 to 26 carbon atoms), a heterocyclic oxy group (preferably a heterocyclic oxy group having 2 to 20 carbon atoms),

an alkoxycarbonyl group (preferably an alkoxycarbonyl group having 2 to 20 carbon atoms), a cycloalkoxycarbonyl group (preferably a cycloalkoxycarbonyl group having 4 to 20 carbon atoms), an aryloxycarbonyl group (preferably an aryloxycarbonyl group having 6 to 20 carbon atoms), an amino group (preferably an amino group having 0 to 20 carbon atoms, including an alkylamino group, an alkenylamino group, an alkynylamino group, a cycloalkylamino group, a cycloalkenylamino group, an arylamino group, and a heterocyclic amino group, for example, amino, N,N-dimethylamino, N,N-diethylamino, N-ethylamino, N-allylamino, N-(2-propynyl)amino, N-cyclohexylamino, N-cyclohexenylamino, N,N-diphenylamino, anilino, pyridylamino, imidazolylamino, benzimidazolylamino, thiazolylamino, benzothiazolylamino, and triazinylamino), a sulfamoyl group (preferably a sulfamoyl group having 0 to 20 carbon atoms, preferably an alkyl-, cycloalkyl-, and aryl-sulfamoyl group), an acyl group (preferably an acyl group having 1 to 20 carbon atoms), an acyloxy group (preferably an acyloxy group having 1 to 20 carbon atoms), a carbamoyl group (preferably a carbamoyl group having 1 to 20 carbon atoms, preferably alkyl-, cycloalkyl-, and aryl-carbamoyl groups),

an acylamino group (preferably an acylamino group having 1 to 20 carbon atoms), a sulfonamido group (preferably a sulfonamido group having 0 to 20 carbon atoms, preferably alkyl-, cycloalkyl-, and aryl-sulfonamido groups), an alkylthio group (preferably an alkylthio group having 1 to 20 carbon atoms, and more preferably an alkylthio group having 1 to 12 carbon atoms, for example, methylthio, ethylthio, isopropylthio, pentylthio, hexylthio, octylthio, and benzylthio), a cycloalkylthio group (preferably a cycloalkylthio group having 3 to 20 carbon atoms), an arylthio group (preferably an arylthio group having 6 to 26 carbon atoms), an alkyl-, cycloalkyl-, and aryl-sulfonyl group (preferably a sulfonyl group having 1 to 20 carbon atoms),

a silyl group (preferably a silyl group having 1 to 20 carbon atoms, preferably alkyl-, aryl-, alkoxy-, and aryloxy-substituted silyl groups), a silyloxy group (preferably a silyloxy group having 1 to 20 carbon atoms, preferably alkyl-, aryl-, alkoxy-, and aryloxy-substituted silyloxy groups), a hydroxyl group, a cyano group, a nitro group, and a halogen atom (for example, a fluorine atom, a chlorine atom, a bromine atom, and iodine atom).

Examples of the group selected from the substituent group $Z^R$ more preferably include an alkyl group, an alkenyl group, a cycloalkyl group, an aryl group, a heterocyclic group, an alkoxy group, a cycloalkoxy group, an aryloxy group, an alkoxycarbonyl group, a cycloalkoxycarbonyl group, an amino group, an acylamino group, a cyano group, and a halogen atom, and particularly preferably include an alkyl group, an alkenyl group, a heterocyclic group, an alkoxy group, an alkoxycarbonyl group, an amino group, an acylamino group, and a cyano group.

When the compound, the substituent, or the like includes an alkyl group, an alkenyl group, or the like, these may be linear or branched, and substituted or unsubstituted. In addition, when the compound, the substituent, or the like includes an aryl group, a heterocyclic group, or the like, these may be a monocycle or a fused ring, and may be substituted or unsubstituted.

Next, preferred aspects of the main members of the photoelectric conversion element and the dye-sensitized solar cell will be described.

<Electrically Conductive Support>

The electrically conductive support is not particularly limited as long as it has electrical conductivity and is capable of supporting a photoconductor layer 2 or the like. The electrically conductive support is preferably an electrically conductive support 1 formed of a material having electrical conductivity, such as a metal, or an electrically conductive support 41 having a glass or plastic substrate 44 and a transparent electrically-conductive film 43 formed on the surface of the substrate 44.

Among them, the electrically conductive support 41 having the transparent electrically-conductive film 43 of a

metal oxide on the surface of the substrate 44 is more preferable. Such the electrically conductive support 41 is obtained by applying an electrically conductive metal oxide onto the surface of the substrate 44 to form a transparent electrically-conductive film 43. Examples of the substrate 44 formed of plastics include the transparent polymer films described in paragraph No. 0153 of JP2001-291534A. Further, as a material which forms the substrate 44, ceramics (JP2005-135902A) or electrically conductive resins (JP2001-160425A) can be used, in addition to glass and plastics. As the metal oxide, tin oxide (TO) is preferable, and indium-tin oxide (tin-doped indium oxide; ITO), and fluorine-doped tin oxide such as tin oxide which has been doped with fluorine (FTO) are particularly preferable. In this case, the coating amount of the metal oxide is preferably 0.1 to 100 g, per square meter of the surface area of the substrate 44. In a case of using the electrically conductive support 41, it is preferable that light is incident from the substrate 44.

It is preferable that the electrically conductive supports 1 and 41 are substantially transparent. The expression, "substantially transparent", means that the transmittance of light (at a wavelength of 300 to 1,200 nm) is 10% or more, preferably 50% or more, and particularly preferably 80% or more.

The thickness of the electrically conductive supports 1 and 41 is not particularly limited, but is preferably 0.05 μm to 10 mm, more preferably 0.1 μm to 5 mm, and particularly preferably 0.3 μm to 4 mm.

In a case of having a transparent electrically-conductive film 43, the thickness of the transparent electrically-conductive film 43 is preferably 0.01 to 30 μm, more preferably 0.03 to 25 μm, and particularly preferably 0.05 to 20 μm.

The electrically conductive supports 1 and 41 may be provided with a light management function at the surface, and may have, for example, the anti-reflection film having a high refractive index film and a low refractive index oxide film alternately laminated described in JP2003-123859A, and the light guide function described in JP2002-260746A on the surface.

<Photoconductor Layer>

As long as the photoconductor layer has semiconductor fine particles 22 carrying the dye 21 and an electrolyte, it is not particularly limited in terms of other configurations. Preferred examples thereof include the photoconductor layer 2 and the photoconductor layer 42.

- Semiconductor Fine Particles (Layer Formed by Semiconductor Fine Particles) -

The semiconductor fine particles 22 are preferably fine particles of chalcogenides of metals (for example, oxides, sulfides, and selenides) or of compounds having perovskite type crystal structures. Preferred examples of the chalcogenides of metals include oxides of titanium, tin, zinc, tungsten, zirconium, hafnium, strontium, indium, cerium, yttrium, lanthanum, vanadium, niobium, or tantalum, cadmium sulfide, and cadmium selenide. Preferred examples of the compounds having perovskite type crystal structures include strontium titanate and calcium titanate. Among these, titanium oxide (titania), zinc oxide, tin oxide, and tungsten oxide are particularly preferable.

Examples of the crystal structure of titania include structures of an anatase type, a brookite type, and a rutile type, with the structures of an anatase type and a brookite type being preferable. A titania nanotube, nanowire, or nanorod may be used singly or in mixture with titania fine particles.

The particle diameter of the semiconductor fine particles 22 is expressed in terms of an average particle diameter using a diameter when a projected area is converted into a circle, and is preferably 0.001 to 1 μm as primary particles, and 0.01 to 100 μm as an average particle diameter of dispersions. Examples of the method for coating the semiconductor fine particles 22 on the electrically conductive supports 1 or 41 include a wet method, a dry method, and other methods.

It is preferable that the semiconductor fine particles 22 have a large surface area so that they may adsorb a large amount of the dye 21. For example, in a state where the semiconductor fine particles 22 are coated on the electrically conductive support 1 or 41, the surface area is preferably 10 times or more, and more preferably 100 times or more, with respect to the projected area. The upper limit of this value is not particularly limited, and the upper limit is usually approximately 5,000 times.

Although a preferred thickness of the layer formed by the semiconductor fine particles may vary depending on the utility of the photoelectric conversion element, the thickness is typically 0.1 to 100 μm.In a case of using the photoelectric conversion element as a dye-sensitized solar cell, the thickness of the layer is more preferably 1 to 50 μm, and still more preferably 3 to 30 μm.

It is preferable that the semiconductor fine particles 22 may be calcined at a temperature of 100°C to 800°C for 10 minutes to 10 hours after being applied on the electrically conductive support 1 or 41, so as to bring about cohesion of the particles. In a case of using glass as a material for the electrically conductive support 1 or the substrate 44 is used, the film-forming temperature is preferably 60°C to 600°C.

The coating amount of the semiconductor fine particles 22 per square meter of the surface area of the electrically conductive support 1 or 41 is preferably 0.5 to 500 g, and more preferably 5 to 100 g.

It is preferable that a short circuit-preventing layer is formed between the electrically conductive support 1 or

41 and the photoconductor layer 2 or 42 so as to prevent reverse current due to a direct contact between the electrolyte included in the photoconductor layer 2 or 42 and the electrically conductive support 1 or 41.

In addition, it is preferable to use a spacer S (see Fig. 2) or a separator, so as to prevent contact between the light-receiving electrode 5 or 40 and the counter electrode 4 or 48.

- Dye -

In the photoelectric conversion element 10 and the dye-sensitized solar cell 20, at least one kind of ruthenium complex dye represented by Formula (1) is used as a sensitizing dye.

In the present invention, examples of the dye that can be used in combination with the ruthenium complex dye represented by Formula (1) include a Ru complex dye other than the ruthenium complex dye represented by Formula (1), a squarylium cyanine dye, an organic dye, a porphyrin dye, and a phthalocyanine dye.

As the dye to be used in combination, Ru complex dyes other than ruthenium complex dye represented by Formula (1), squarylium cyanine dyes, or organic dyes are preferable.

The overall amount of the dye to be used is preferably 0.01 to 100 millimoles, more preferably 0.1 to 50 millimoles, and particularly preferably 0.1 to 10 millimoles, per square meter of the surface area of the electrically conductive support 1 or 41. Further, the amount of the dye 21 to be adsorbed onto the semiconductor fine particles 22 is preferably 0.001 to 1 millimole, and more preferably 0.1 to 0.5 millimoles, with respect to 1 g of the semiconductor fine particles 22. By setting the amount of the dye to such a range, the sensitization effect on the semiconductor fine particles 22 is sufficiently obtained.

In a case where the ruthenium complex dye represented by Formula (1) is used in combination with another dye, the ratio of the mass of the ruthenium complex dye represented by Formula (1)/the mass of another dye is preferably 95/5 to 10/90, more preferably 95/5 to 50/50, still more preferably 95/5 to 60/40, particularly preferably 95/5 to 65/35, and most preferably 95/5 to 70/30.

After the dye is carried onto the semiconductor fine particles 22, the surface of the semiconductor fine particles 22 may be treated using an amine compound. Preferred examples of the amine compound include pyridine compounds (for example, 4-t-butylpyridine and polyvinylpyridine). These may be used as they are in a case where they are liquids, or may be used in a state where they are dissolved in an organic solvent.

- Co-Adsorbent -

In the present invention, it is preferable to further use a co-adsorbent together with the ruthenium complex dye represented by Formula (1) or with another dye to be used in combination, if necessary. Such a co-adsorbent which includes a co-adsorbent having at least one acidic group (preferably a carboxyl group or a salt thereof) is preferable, and examples thereof include a fatty acid and a compound having a steroid skeleton.

The fatty acid may be a saturated fatty acid or an unsaturated fatty acid, and examples thereof include butanoic acid, hexanoic acid, octanoic acid, decanoic acid, hexadecanoic acid, dodecanoic acid, palmitic acid, stearic acid, oleic acid, linoleic acid, and linolenic acid.

Examples of the compound having a steroid skeleton include cholic acid, glycocholic acid, chenodeoxycholic acid, hyocholic acid, deoxycholic acid, lithocholic acid, and ursodeoxycholic acid, among which cholic acid, deoxycholic acid, and chenodeoxycholic acid are preferable; and deoxycholic acid are more preferable.

As the co-adsorbent, the co-adsorbent represented by Formula (CA) described in paragraph Nos. 0125 to 0129 of JP2014-82187A is preferable, and the description of paragraph Nos. 0125 to 0129 of JP2014-82187A are preferably incorporated herein by reference.

By making the co-adsorbent adsorbed onto the semiconductor fine particles 22, the co-adsorbent exhibits an effect of suppressing the inefficient association of the ruthenium complex dye and an effect of preventing reverse electron transfer from the surface of the semiconductor fine particles to the redox system in the electrolyte. The amount of the co-adsorbent to be used is not particularly limited, and from the viewpoint of exhibiting the above effects effectively, the amount is preferably 1 to 200 moles, more preferably 10 to 150 moles, and particularly preferably 20 to 50 moles, with respect to 1 mole of the ruthenium complex dye.

- Light-Scattering Layer -

In the present invention, the light-scattering layer is different from the semiconductor layer that it has a function of scattering incidence rays.

In the dye-sensitized solar cell 20, the light-scattering layer 46 preferably contains rod-shaped or plate-shaped metal oxide fine particles. Examples of the metal oxide to be used in the light-scattering layer 46 include the chalcogenides (oxides) of the metals, described as the compound that forms the semiconductor fine particles. In a case of providing

the light-scattering layer 46, it is preferable that the thickness of the light-scattering layer is set to 10% to 50% of the thickness of the photoconductor layer 42.

The light-scattering layer 46 is preferably the light-scattering layer described in JP2002-289274A, and the description of JP2002-289274A is preferably incorporated herein by reference.

<Charge Transfer Layer>

The charge transfer layers 3 and 47 used in the photoelectric conversion element of the present invention are layers having a function of complementing electrons for the oxidized forms of the dye 21, and are provided between the light-receiving electrode 5 or 40 and the counter electrode 4 or 48.

The charge transfer layers 3 and 47 include electrolytes. Here, the expression, "the charge transfer layer includes an electrolyte", is used to inclusion of both of an aspect in which the charge transfer layer consists of only electrolytes and an aspect in which the charge transfer layer consists of electrolytes and materials other than the electrolytes.

The charge transfer layers 3 and 47 may be any of a solid form, a liquid form, a gel form, or a mixture thereof.

- Electrolyte -

Examples of the electrolyte include a liquid electrolyte having a redox pair dissolved in an organic solvent, and a so-called gel electrolyte in which a molten salt containing a redox pair and a liquid having a redox pair dissolved in an organic solvent are impregnated in a polymer matrix. Among those, from the viewpoint of photoelectric conversion efficiency, a liquid electrolyte is preferable.

Examples of the redox pair include a combination of iodine and an iodide (preferably an iodide salt or an iodide ionic liquid, and preferably lithium iodide, tetrabutylammonium iodide, tetrapropylammonium iodide, and methylpropylimidazolium iodide), a combination of an alkylviologen (for example, methylviologen chloride, hexylviologen bromide, and benzylviologen tetrafluoroborate) and a reductant thereof, a combination of a polyhydroxybenzene (for example, hydroquinone and naphthohydroquinone) and an oxidized form thereof, a combination of a divalent iron complex and a trivalent iron complex (for example, a combination of potassium ferricyanide and potassium ferrocyanide), and a combination of a divalent cobalt complex and a trivalent cobalt complex. Among these, a combination of iodine and an iodide, or a combination of a divalent cobalt complex and a trivalent cobalt complex is preferable, and a combination of iodine and an iodide is particularly preferable.

As the cobalt complex, the complex represented by Formula (CC) described in paragraph Nos. 0144 to 0156 of JP2014-82189A is preferable, and the description of paragraph Nos. 0144 to 0156 of JP2014-82189A is preferably incorporated in the present specification.

In a case where a combination of iodine and iodide is used as an electrolyte, it is preferable that a nitrogen-containing aromatic cation iodide salt as a 5- or 6-membered ring is additionally used.

The organic solvent which is used in a liquid electrolyte and a gel electrolyte is not particularly limited, but is preferably an aprotic polar solvent (for example, acetonitrile, propylene carbonate, ethylene carbonate, dimethylformamide, dimethylsulfoxide, sulfolane, 1,3-dimethylimidazolinone, and 3-methyloxazolidinone).

In particular, as the organic solvent which is used for a liquid electrolyte, a nitrile compound, an ether compound, an ester compound, or the like is preferable, a nitrile compound is more preferable, and acetonitrile or methoxypropionitrile is particularly preferable.

With regard to the molten salt or the gel electrolyte, those described in paragraph No. 0205 and paragraph Nos. 0208 to 0213 of JP2014-139931A are preferable, and the descriptions of paragraph No. 0205 and paragraph Nos. 0208 to 0213 of JP2014-139931A are preferably incorporated herein by reference.

The electrolyte may contain aminopyridine compounds, benzimidazole compounds, aminotriazole compounds, aminothiazole compounds, imidazole compounds, aminotriazine compounds, urea compounds, amide compounds, pyrimidine compounds, and heterocycles not including nitrogen, in addition to pyridine compounds such as 4-t-butylpyridine, as an additive.

Moreover, a method of controlling the moisture content of the electrolytic solution may be employed in order to enhance the photoelectric conversion efficiency. Preferred examples of the method of controlling the moisture content include a method of controlling the concentration, and a method of adding a dehydrating agent. The moisture content of the electrolytic solution is preferably adjusted to 0% to 0.1% by mass.

Iodine can also be used as a clathrate compound of iodine with cyclodextrin. Furthermore, a cyclic amidine may be used, or an antioxidant, a hydrolysis inhibitor, a decomposition inhibitor, or zinc iodide may be added.

A solid-state charge transport layer such as a p-type semiconductor or a hole transport material, for example, CuI or CuNCS, may be used in place of the liquid electrolyte and the quasi-solid-state electrolyte as described above. Moreover, the electrolytes described in Nature, vol. 486, p. 487 (2012) and the like may also be used. For a solid-state

charge transport layer, an organic hole transport material may be used. As the organic hole transport material, those described in paragraph No. 0214 of JP2014-139931A are preferable.

The redox pair serves as an electron carrier, and accordingly, it is preferably contained at a certain concentration. The concentration of the redox pair in total is preferably 0.01 mol/L or more, more preferably 0.1 mol/L or more, and particularly preferably 0.3 mol/L or more. In this case, the upper limit is not particularly limited, but is usually approximately 5 mol/L.

<Counter Electrode>

The counter electrodes 4 and 48 preferably work as a positive electrode in a dye-sensitized solar cell. The counter electrodes 4 and 48 usually have the same configurations as the electrically conductive support 1 or 41, but in a configuration in which strength is sufficiently maintained, a substrate 44 is not necessarily required. A preferred structure of the counter electrodes 4 and 48 is a structure having a high charge collecting effect. At least one of the electrically conductive support 1 or 41 and the counter electrode 4 or 48 should be substantially transparent so that light may reach the photoconductor layers 2 and 42. In the dye-sensitized solar cell of the present invention, the electrically conductive support 1 or 41 is preferably transparent to allow sunlight to be incident from the side of the electrically conductive support 1 or 41. In this case, the counter electrodes 4 and 48 more preferably have light reflecting properties. As the counter electrodes 4 and 48 of the dye-sensitized solar cell, glass or plastics on which a metal or an electrically conductive oxide is deposited are preferable, and glass on which platinum is deposited is particularly preferable. In the dye-sensitized solar cell, a lateral side of the cell is preferably sealed with a polymer, an adhesive, or the like in order to prevent evaporation of components.

[Method for Producing Photoelectric Conversion Element and Dye-Sensitized Solar Cell]

The photoelectric conversion element and the dye-sensitized solar cell of the present invention can be produced using a dye solution (the dye solution of the present invention) containing the ruthenium complex dye of the present invention and a solvent.

Such a dye solution is formed by dissolving the ruthenium complex dye of the present invention in a solvent, and may also include other components such as the co-adsorbent, if necessary.

Examples of the solvent to be used include the solvents described in JP2001-291534A, but are not particularly limited thereto. In the present invention, an organic solvent is preferable, and an alcohol solvent, an amide solvent, a nitrile solvent, a ketone solvent, a hydrocarbon solvent, and a mixed solvent of two or more kinds of these solvents are more preferable. As the mixed solvent, a mixed solvent of an alcohol solvent and a solvent selected from an amide solvent, a nitrile solvent, a ketone solvent, and a hydrocarbon solvent is preferable; a mixed solvent of an alcohol solvent and an amide solvent, a mixed solvent of an alcohol solvent and a hydrocarbon solvent, and a mixed solvent of an alcohol solvent and a nitrile solvent are more preferable; and a mixed solvent of an alcohol solvent and an amide solvent, and a mixed solvent of an alcohol solvent and a nitrile solvent are particularly preferable. Specifically, a mixed solvent of at least one of methanol, ethanol, propanol, or butanol, and at least one of dimethylformamide or dimethylacetamide, and a mixed solvent of at least one of methanol, ethanol, propanol, or t-butanol, and acetonitrile are preferable.

The dye solution preferably contains a co-adsorbent, and as the co-adsorbent, the aforementioned co-adsorbent is preferable.

Here, the dye solution of the present invention is preferably a dye solution in which the concentrations of the ruthenium complex dye and the co-adsorbent have been adjusted so that the solution can be used as it is during the production of the photoelectric conversion element or the dye-sensitized solar cell. In the present invention, the dye solution of the present invention preferably contains 0.001% to 0.1% by mass of the ruthenium complex dye of the present invention. The amount of the co-adsorbent to be used is as described above.

For the dye solution, it is preferable to adjust the moisture content, and thus in the present invention, the moisture content is preferably adjusted to 0% to 0.1% by mass.

In the present invention, it is preferable to manufacture a photoconductor layer by carrying the ruthenium complex dye represented by Formula (1) or a dye including the same onto the surface of the semiconductor fine particles, using the dye solution. That is, the photoconductor layer is preferably formed by applying (including a dip method) the dye solution onto the semiconductor fine particles provided on the electrically conductive support, followed by drying and curing.

By further providing a charge transfer layer, a counter electrode, or the like for a light-receiving electrode including the photoconductor layer as manufactured above, the photoelectric conversion element of the present invention can be obtained.

The dye-sensitized solar cell is produced by connecting an external circuit 6 with the electrically conductive support 1 and the counter electrode 4 of the photoelectric conversion element manufactured as above.

By using the dye solution of the present invention, the adsorption amount onto the surface of semiconductor fine particles can be increased, and both of the photoelectric conversion efficiency and the moisture resistance in the obtained photoelectric conversion element or dye-sensitized solar cell can be realized to a high extent of level.

EXAMPLES

Hereinafter, the present invention will be described in more detail, based on Examples, but the present invention is not limited thereto.

Example 1

[Preparation of Ruthenium Complex Dye]

The structures of the ruthenium complex dyes (D-1) to (D-7) of the present invention, and the ruthenium complex dyes (D-8) and (D-9) of Comparative Examples are shown below.

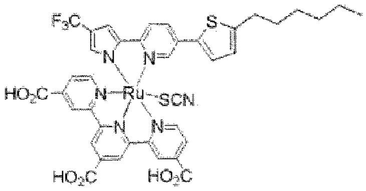

D-1

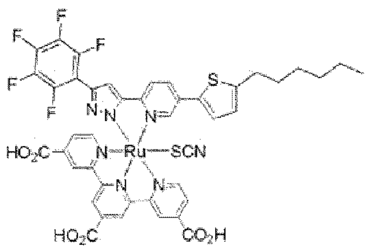

D-2

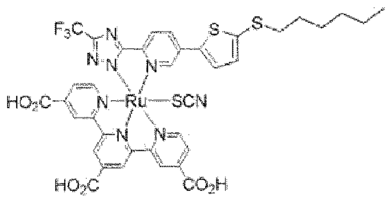

D-3

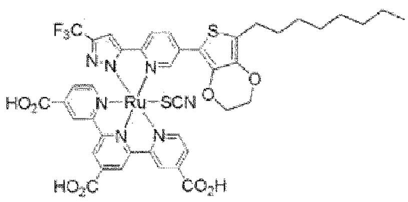

D-4

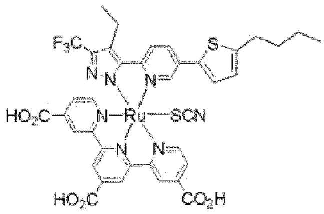

D-5

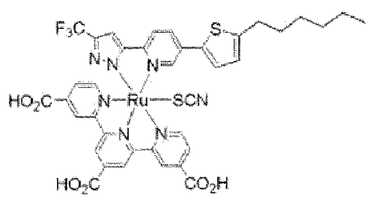

D-6

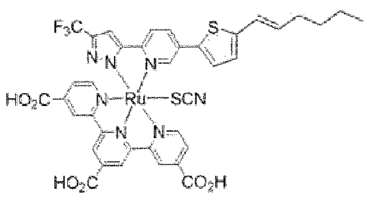

D-7

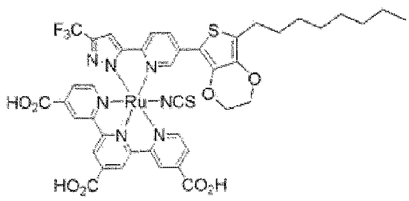

D-8

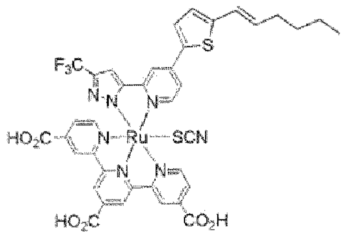

D-9

(Synthesis of Ruthenium Complex Dye (D-6))

According to the following scheme, a ruthenium complex dye (D-6) was synthesized. The definitions of the abbreviations in the following scheme and the specification are as follows.

Ph: Phenyl
THF: Tetrahydrofuran
Et: Ethyl
$^t$Bu: t-Butyl
Me: Methyl
DMF: N,N-Dimethylformamide

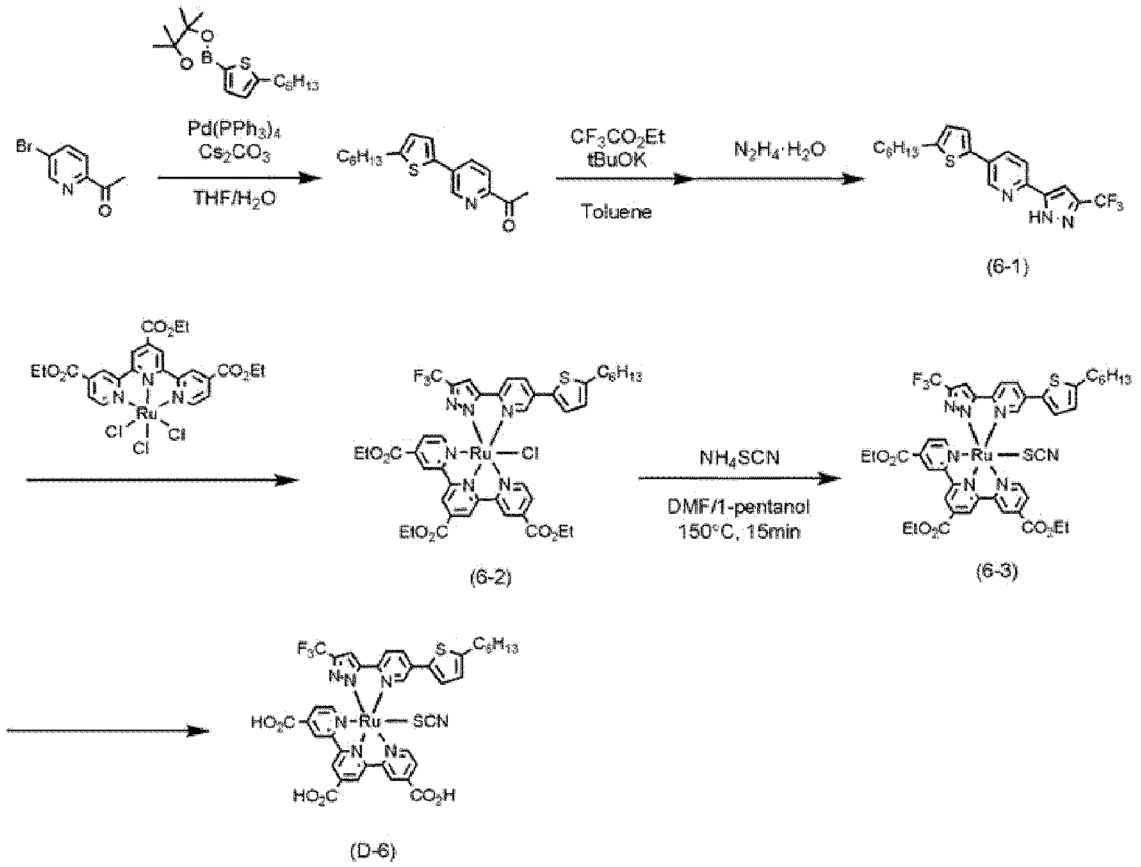


(6-1)

(6-2)

(6-3)

(D-6)

That is, with reference to the synthesis method for PRT-21 described in Journal of Materials Chemistry A, 2014, 2, 17618-17627 and Electronic supplementary information in this publication, synthesis was performed in the following manner. First, a compound (6-1) was reacted with a Ru-terpyridine complex, and then a compound (6-2) was isolated by silica gel column chromatography. In the next procedure, synthesis was performed in the same manner as the synthesis method for PRT-21 except that the reaction was performed at 150°C for 15 minutes, using a mixed solvent (1:1 in the volume ratio) of DMF and 1-pentanol, in the synthesis of the compound (6-3). By mass spectrometry and HPLC analysis, it was confirmed that D-6 is a bond isomer (an isomer in which an NCS ligand of Dye3 was changed to an SCN ligand) in Dye3 described in JP2013-72080A. From the results of HPLC measurement under the above-mentioned conditions, a dye having an NCS ligand (an NCS form which has an N atom as a monodentate ligand and coordinates to ruthenium) was not detected (that is, the detected dyes were all SCN ligands (an SCN form which has an S atom as a monodentate ligand and coordinates to ruthenium)).
Ruthenium Complex Dye (D-6)

HPLC retention time: 12.2 minutes
ESI-MS m/z = 904.1 ($M+H^+$)
Comparative (bond isomer of the ruthenium complex dye (D-6) (Dye3 described in JP2013-72080A)
HPLC retention time: 15.5 minutes

(Preparation of Ruthenium Complex Dyes (D-1) to (D-5), and (D-7) to (D-9))

In the same manner as for the ruthenium complex dye (D-6), ruthenium complex dyes (D-1) to (D-5), (D-7), and (D-9) were prepared.
In addition, the ruthenium complex dye (D-8) (NCS form) was synthesized in accordance with the method described in the specification of US2012/0111410A.
The prepared ruthenium complex dyes (D-1) to (D-9) were each identified by MS (mass spectrum) measurement. The summary of the results thereof are shown in Table 1 below. Further, as a result of the HPLC measurement under the above-mentioned conditions, the prepared dyes (D-1) to (D-5), (D-7), and (D-9) were all SCN forms, and the dye (D-8) was an NCS form.

[Table 1]

| Ruthenium complex dye | m/z (ESI-MS) |
|---|---|
| D-1 | 903.1 (M+H$^+$) |
| D-2 | 1002.1 (M+H$^+$) |
| D-3 | 937.0 (M+H$^+$) |
| D-4 | 990.1 (M+H$^+$) |
| D-5 | 904.1 (M+H$^+$) |
| D-6 | 904.1 (M+H$^+$) |
| D-7 | 902.1 (M+H$^+$) |
| D-8 | 990.1 (M+H$^+$) |
| D-9 | 902.1 (M+H$^+$) |

[Production of Dye-Sensitized Solar Cell]

Using the ruthenium complex dyes (D-1) to (D-9) synthesized in [Synthesis of Ruthenium Complex Dye], a dye-sensitized solar cell 20 (in a dimension of 5 mm × 5 mm) shown in Fig. 2 was produced. This production was carried out by the method shown below. For each of the produced dye-sensitized solar cells 20, the following performance was evaluated.

(Manufacture of Light-Receiving Electrode Precursor)

An electrically conductive support 41 was manufactured in which a fluorine-doped $SnO_2$ electrically-conductive film (transparent electrically-conductive film 43, film thickness; 500 nm) was formed on a glass substrate (substrate 44, thickness of 4 mm). Further, a titania paste "18NR-T" (manufactured by DyeSol) was screen-printed on the $SnO_2$ electrically-conductive film, followed by drying at 120°C. Then, the dried titania paste "18NR-T" was screen-printed again, followed by drying at 120°C for 1 hour. Thereafter, the dried titania paste was calcined at 500°C to form a semiconductor layer 45 (layer thickness; 10 μm). A titania paste "18NR-AO" (manufactured by DyeSol) was screen-printed on the semiconductor layer 45, followed by drying at 120°C for 1 hour. Then, the dried titania paste was calcined at 500°C to form a light-scattering layer 46 (layer thickness; 5 μm) on the semiconductor layer 45.

Thus, a photoconductor layer 42 (the area of the light-receiving surface; 5 mm × 5 mm, layer thickness; 15 μm, a ruthenium complex dye being not carried) was formed on the $SnO_2$ electrically-conductive film, thereby manufacturing a light-receiving electrode precursor A not carrying a ruthenium complex dye.

(Adsorption of Dye)

Next, each of the ruthenium complex dyes (D-1) to (D-9) synthesized in [Synthesis of Ruthenium Complex Dye] was carried onto the photoconductor layer 42 not carrying a ruthenium complex dye as shown below. First, the ruthenium complex dye was dissolved in a mixed solvent of t-butanol and acetonitrile at 1:1 (volume ratio) such that the concentration of the ruthenium complex dye was $2 \times 10^{-4}$ mol/L. Further, 30 moles of deoxycholic acid as a co-adsorbent was added to one mole of the ruthenium complex dye, thereby preparing each of dye solutions. Next, the light-receiving electrode precursor was immersed in each of the dye solutions at 25°C for 20 hours and dried after pulling out from the dye solution.

Thus, each of light-receiving electrodes 40 having the respective ruthenium complex dyes carried on the light-receiving electrode precursor was manufactured.

(Assembly of Dye-Sensitized Solar Cell)

Then, a platinum electrode (the thickness of a Pt thin film; 100 nm) having the same shape and size as those of the electrically conductive support 41 was manufactured as a counter electrode 48. Further, 0.1 M of iodine, 0.1 M of lithium iodide, 0.5 M of 4-t-butylpyridine, and 0.6 M of 1,2-dimethyl-3-propylimidazolium iodide were dissolved in acetonitrile to prepare a liquid electrolyte as an electrolytic solution. Further, a Spacer S "SURLYN" (trade name, manufactured by E. I. du Pont de Nemours and Company), which has a shape matching to the size of the photoconductor layer 42, was prepared.

Each of the light-receiving electrodes 40 manufactured as above and the counter electrode 48 were arranged to face each other through the Spacer S and thermally compressed, and then the liquid electrolyte was filled from the inlet for the electrolytic solution between the photoconductor layer 42 and the counter electrode 48, thereby forming a charge transfer layer 47. The outer periphery and the inlet for the electrolytic solution of thus manufactured cell were sealed and cured using RESIN XNR-5516 (trade name, manufactured by Nagase ChemteX Corporation), thereby producing each of dye-sensitized solar cells (Sample Nos. 101 to 107, c01, and 02).

(Evaluation of Adsorption Amount)

The adsorption amount was evaluated in the following manner.

In the same manner as the preparation of the dye solution in (Dye Adsorption), each of dye solutions including dyes of D-1 to D-9 was prepared. The light-receiving electrode precursor prepared in the same manner as for the preparation of the light-receiving electrode precursors in (Manufacture of Light-Receiving Electrode Precursor) was immersed in the dye solution at 25°C for 20 hours to produce a light-receiving electrode 40. Each of the obtained light-receiving electrodes 40 was immersed in a 10% methanol solution (3 mL) of tetrabutylammonium hydroxide, and shaken for 16 hours with a twist mixer (Model No.: TM-300, manufactured by AS ONE Corporation) under the conditions of a temperature of 20°C and a rotation speed of 45 rpm, whereby the ruthenium complex dye adsorbed on the light-receiving electrode 40 was released. With regard to the 10% methanol solution of tetrabutylammonium hydroxide in which the released ruthenium complex dye was dissolved, an ultraviolet-visible absorption spectrum was measured as it was. Further, the adsorption molar amount (mmol) of the ruthenium complex dye with respect to the light-receiving electrode 40 was calculated from a calibration curve that had been previously prepared, and divided by the surface area ($cm^2$) of the electrically conductive support 41, thereby calculating the adsorption amount ($mmol/cm^2$) of the ruthenium complex dye with respect to the light-receiving electrode 40. In addition, it was confirmed that all the adsorbed ruthenium complex dyes were released from the light-receiving electrodes 40 under the release conditions, by visually observing that a film of titanium oxide on which the dye had been adsorbed was decolorized and turned white.

When the adsorption amount ($mmol/cm^2$) of the ruthenium complex dye (D-8) was taken as 1, the adsorption amount of each dye of D-1 to D-7, and D-9 with respect to the adsorption amount of D-8 taken as 1 was determined as a relative value. Thus, the adsorption amount of each dye on the surface of semiconductor fine particles was evaluated in accordance with the following evaluation standard. In the following evaluation standard, "A" and "B" are acceptable levels in the present invention.

- Evaluation Standard -

A: The relative value of the adsorption amount of the dye is more than 1.1.
B: The relative value of the adsorption amount of the dye is more than 1.0 and 1.1 or less.
C: The relative value of the adsorption amount of the dye is more than 0.9 and 1.0 or less.
D: The relative value of the adsorption amount of the dye is 0.9 or less.

(Evaluation of Moisture Resistance)

The cells (Sample Nos. 101 to 107, c01, and c02) produced in (Assembly of Dye-Sensitized Solar Cell) were each stored in a dark room at a temperature of 25°C and a humidity of 85% for 500 hours. With regard to each of the cells with Sample Nos., the photoelectric conversion efficiency ($W_i$) of the cell before storage and the photoelectric conversion efficiency ($W_{500}$) of the cell after storage were measured to calculate a reduction rate in the photoelectric conversion efficiency from the following equation.

The photoelectric conversion efficiency was measured by carrying out a cell characteristic test through irradiation with artificial sunlight of 1,000 W/m2 from a xenon lamp through an AM1.5 filter, using a solar simulator (trade name "WXS-85H", manufactured by WACOM ELECTRIC CO., LTD.), and measuring current-voltage characteristics using an I-V tester.

$$\text{Reduction rate in photoelectric conversion efficiency (\%)} = 100 \times (W_i - W_{500})/W_i$$

The moisture resistance was evaluated in accordance with the following evaluation standard, based on the reduction rate in the photoelectric conversion efficiency. In the following evaluation standard, "A" and "B" are acceptable

levels in the present invention.

- Evaluation Standard for Moisture Resistance -

A: The reduction rate in the photoelectric conversion efficiency is less than 8%.
B: The reduction rate in the photoelectric conversion efficiency is 8% or more and less than 12%.
C: The reduction rate in the photoelectric conversion efficiency is 12% or more and less than 15%.
D: The reduction rate in the photoelectric conversion efficiency is 15% or more.

The summary of the results is shown in Table 2.

Furthermore, the $W_i$ of each of the dye-sensitized solar cells in which each of the ruthenium complex dyes (SCN forms) was used as a sensitizing dye was at the equivalent level, as compared with the $W_i$ of each of the dye-sensitized solar cells, produced in the same manner as above a sensitizing dye after preparing an NCS form which is a bond isomer of each dye.

[Table 2]

| Sample Nos. | Ruthenium complex dye | Evaluation | | Note |
|---|---|---|---|---|
| | | Adsorption amount | Moisture resistance | |
| 101 | D-1 | B | B | Present invention |
| 102 | D-2 | B | A | Present invention |
| 103 | D-3 | A | A | Present invention |
| 104 | D-4 | A | A | Present invention |
| 105 | D-5 | B | A | Present invention |
| 106 | D-6 | A | A | Present invention |
| 107 | D-7 | A | A | Present invention |
| c01 | D-8 | C | C | Comparative Example |
| c02 | D-9 | D | C | Comparative Example |

As shown in Table 2, it could be seen that with all of the ruthenium complex dyes of the present invention, the adsorption amount onto the surface of semiconductor fine particles were increased, and thus, all of the dye-sensitized solar cells using the ruthenium complex dyes of the present invention hardly reduce the photoelectric conversion efficiency, have excellent moisture resistance, and exhibit stable cell performance even when they were stored in a high-humidity environment.

In contrast, in all of the cells using Sample No. c01 using the ruthenium complex dye (D-8) to which NCS (isothiocyanate group) coordinates through a nitrogen atom, and Sample No. c02 using the ruthenium complex dye (D-9) having a nitrogen-containing, 5-membered ring-pyridine ring bidentate ligand at the 4-position with respect to the nitrogen atom through which the substituent $G^2$ coordinates to ruthenium, the adsorption amount of the ruthenium complex dye onto the surface of semiconductor fine particles was small and sufficient moisture resistance could not be obtained.

Although the present invention has been described with reference to embodiments, it is not intended that the present invention is not limited by any of the details of the description unless otherwise specified, but should rather be construed broadly within the spirit and scope of the present invention as set out in the accompanying claims.

The present application claims the priority based on JP2015-054033 filed on March 17, 2015, the contents of which are incorporated by reference into a part described herein.

Explanation of References

1, 41: Electrically conductive support

2, 42: Photoconductor layer
21: Dye
22: Semiconductor fine particles
3, 47: Charge transfer layer
4, 48: Counter electrode
5, 40: Light-receiving electrode
6: External circuit
10: Photoelectric conversion element
100: System in which photoelectric conversion element is applied to cell uses
M: Operating means (for example, electric motor)
20: Dye-sensitized solar cell
43: Transparent electrically-conductive film
44: Substrate
45: Semiconductor layer
46: Light-scattering layer
S: Spacer

## Claims

**1.** A photoelectric conversion element comprising:

an electrically conductive support;
a photoconductor layer including an electrolyte;
a charge transfer layer including an electrolyte; and
a counter electrode,
wherein the photoconductor layer has semiconductor fine particles carrying a ruthenium complex dye represented by Formula (1),

$$RuL^1L^2SCN \qquad (1)$$

in the formula, $L^1$ represents a tridentate ligand represented by Formula (L1), and $L^2$ represents a bidentate ligand represented by Formula (L2),

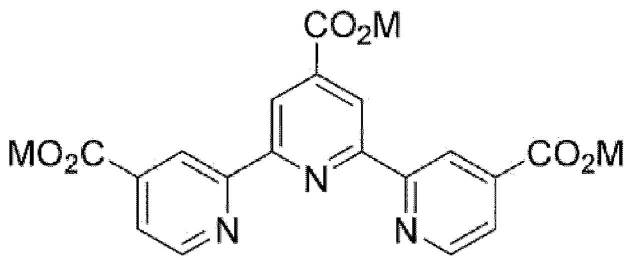
Formula (L1)

in the formula, M's each independently represent a hydrogen ion or a cation,

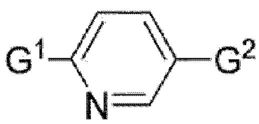
Formula (L2)

in the formula, $G^1$ represents a group represented by any one of Formulae (G1-1) to (G1-3), and $G^2$ represents a group represented by Formula (G2),

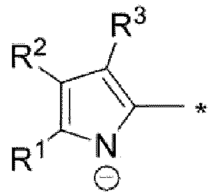 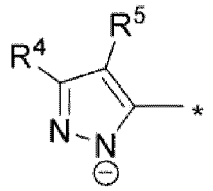 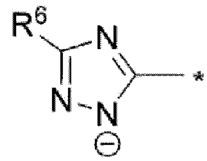

Formula (G1-1) Formula (G1-2) Formula (G1-3)

in the formulae, $R^1$ to $R^6$ each independently represent a hydrogen atom, an alkyl group, a heteroaryl group, an aryl group, or a halogen atom, and * represents a bonding moiety to the pyridine ring in Formula (L2),

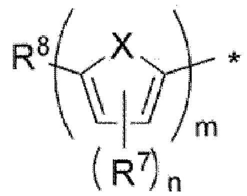 Formula (G2)

in the formula, $R^7$ represents an alkyl group, an alkynyl group, an alkenyl group, an alkoxy group, an alkylthio group, an amino group, a heteroaryl group, or an aryl group, $R^8$ represents a hydrogen atom, an alkyl group, an alkynyl group, an alkenyl group, an alkoxy group, an alkylthio group, an amino group, a heteroaryl group, or an aryl group, m represents an integer of 1 to 3, n represents an integer of 0 to 2, X represents an oxygen atom, a sulfur atom, $NR^f$, a selenium atom, $CR^f_2$, or $SiR^f_2$, in which $R^f$ represents a hydrogen atom, an alkyl group, or an aryl group, and * represents a bonding moiety to the pyridine ring in Formula (L2).

**2.** The photoelectric conversion element according to claim 1,

wherein in Formula (G2), X is a sulfur atom.

**3.** The photoelectric conversion element according to claim 1 or 2,

wherein in Formula (L2), $G^1$ is represented by Formula (G1-2) or Formula (G1-3).

**4.** The photoelectric conversion element according to any one of claims 1 to 3,

wherein in Formula (G1-2), $R^4$ is an alkyl group.

**5.** The photoelectric conversion element according to any one of claims 1 to 4,

wherein in Formula (G1-2), $R^5$ is a hydrogen atom.

**6.** A dye-sensitized solar cell comprising the photoelectric conversion element according to any one of claims 1 to 5.

**7.** A ruthenium complex dye represented by Formula (1),

$RuL^1L^2SCN$ (1)

in the formula, $L^1$ represents a tridentate ligand represented by Formula (L1), and $L^2$ represents a bidentate ligand represented by Formula (L2),

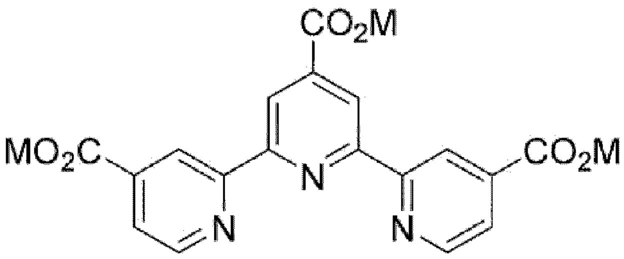

Formula (L1)

in the formula, M's each independently represent a hydrogen ion or a cation,

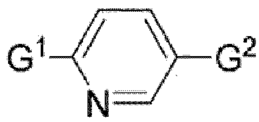

Formula (L2)

in the formula, $G^1$ represents a group represented by any one of Formulae (G1-1) to (G1-3), and $G^2$ represents a group represented by Formula (G2),

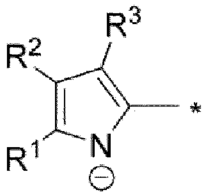

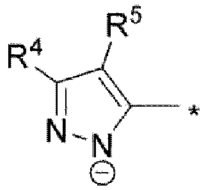

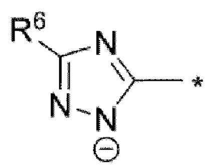

Formula (G1-1) Formula (G1-2) Formula (G1-3)

in the formulae, $R^1$ to $R^6$ each independently represent a hydrogen atom, an alkyl group, a heteroaryl group, an aryl group, or a halogen atom, and * represents a bonding moiety to the pyridine ring in Formula (L2),

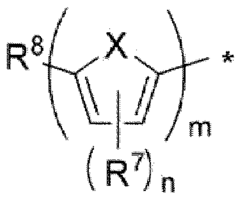

Formula (G2)

in the formula, $R^7$ represents an alkyl group, an alkynyl group, an alkenyl group, an alkoxy group, an alkylthio group, an amino group, a heteroaryl group, or an aryl group, $R^8$ represents a hydrogen atom, an alkyl group, an alkynyl group, an alkenyl group, an alkoxy group, an alkylthio group, an amino group, a heteroaryl group, or an aryl group, m represents an integer of 1 to 3, n represents an integer of 0 to 2, X represents an oxygen atom, a sulfur atom, $NR^1$, a selenium atom, $CR^f_2$, or $SiR^f_2$, in which $R^f$ represents a hydrogen atom, an alkyl group, or an aryl group, and * represents a bonding moiety to the pyridine ring in Formula (L2).

**8.** A dye solution comprising the ruthenium complex dye according to claim 7.

FIG. 1

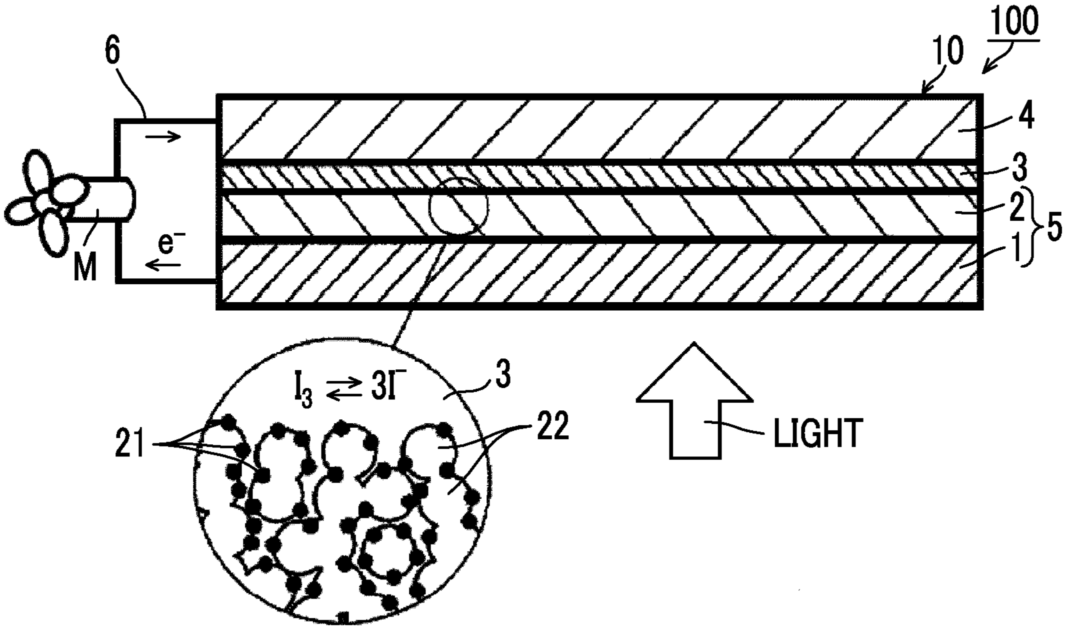


FIG. 2

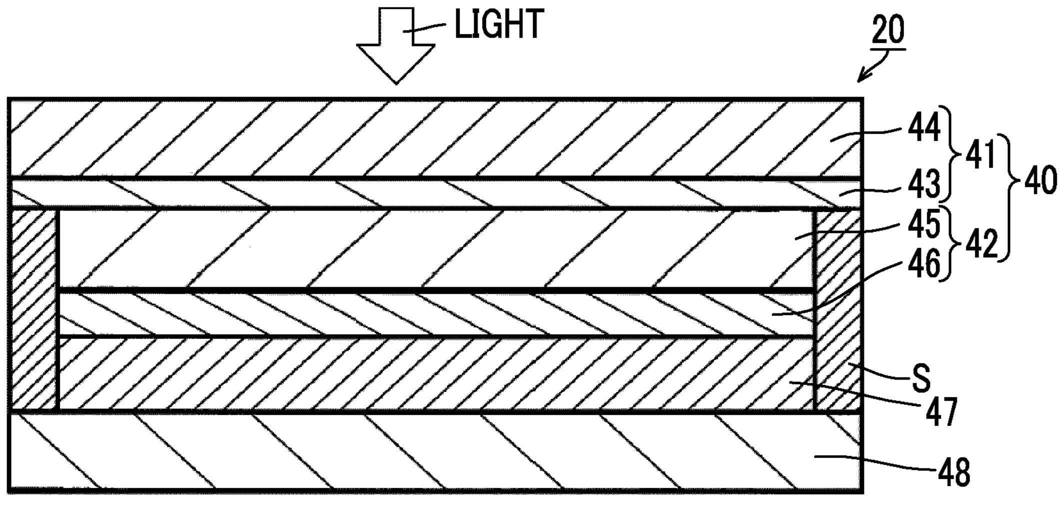

**INTERNATIONAL SEARCH REPORT**

International application No. PCT/JP2016/057952

A. CLASSIFICATION OF SUBJECT MATTER
*H01G9/20*(2006.01)i, *C09B57/10*(2006.01)i

According to International Patent Classification (IPC) or to both national classification and IPC

B. FIELDS SEARCHED

Minimum documentation searched (classification system followed by classification symbols)
H01G9/20, C09B57/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | JP 2014-209589 A (Fujifilm Corp.), 06 November 2014 (06.11.2014), claims; examples & US 2016/0012977 A1 claims; examples & WO 2014/157005 A1 & TW 201446777 A & KR 10-2015-0092259 A & CN 104937686 A | 1-8 |
| A | WO 2014/168163 A1 (Fujifilm Corp.), 16 October 2014 (16.10.2014), claims; examples & JP 2014-207156 A | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 May 2016 (30.05.16) | 07 June 2016 (07.06.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

INTERNATIONAL SEARCH REPORT

International application No. PCT/JP2016/057952

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-67976 A (JSR Corp.), 02 April 2009 (02.04.2009), claims; examples & EP 2036955 A1 claims; examples | 1-8 |
| A | WO 2014/092066 A1 (Sharp Corp.), 19 June 2014 (19.06.2014), claims; examples & EP 2933874 A1 claims; examples | 1-8 |
| A | US 2012/0073660 A1 (CHI, Yun), 29 March 2012 (29.03.2012), claims; examples & TW 201213309 A | 1-8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014209578 A
- JP 2013072080 A
- US 4927721 A
- US 4684537 A
- US 5084365 A
- US 5350644 A
- US 5463057 A
- US 5525440 A
- JP 7249790 A
- JP H07249790 A
- JP 2001185244 A
- JP 2001210390 A
- JP 2003217688 A
- JP 2004220974 A
- JP 2008135197 A
- JP 2013084594 A
- JP 4298799 B
- US 20130018189 A1
- US 20120073660 A1
- US 20120111410 A1
- US 20100258175 A1
- JP 2001291534 A
- JP 2005135902 A
- JP 2001160425 A
- JP 2003123859 A
- JP 2002260746 A
- JP 2014082187 A
- JP 2002289274 A
- JP 2014082189 A
- JP 2014139931 A
- US 20120111410 A
- JP 2015054033 A

### Non-patent literature cited in the description

- *Angew. Chem. Int. Ed.,* 2011, vol. 50, 2054-2058
- *Chem. Commun.,* 2014, vol. 50, 6379-6381
- *Nature,* 2012, vol. 486, 487
- *Journal of Materials Chemistry A,* 2014, vol. 2, 17618-17627